(19) Europäisches Patentamt
European Patent Office
Office européen des brevets

(11) **EP 2 381 596 B1**

(12) **EUROPEAN PATENT SPECIFICATION**

(45) Date of publication and mention
of the grant of the patent:
**09.11.2016 Bulletin 2016/45**

(51) Int Cl.:
*H04B 10/61* (2013.01)          *H04L 27/227* (2006.01)
*H04L 27/22* (2006.01)          *H04L 27/00* (2006.01)
*H04L 27/38* (2006.01)          *H03H 17/02* (2006.01)

(21) Application number: **10305420.1**

(22) Date of filing: **21.04.2010**

(54) **Parallel digital filter**

Paralleler Digitalfilter

Filtre numérique parallèle

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**26.10.2011 Bulletin 2011/43**

(73) Proprietor: **ALCATEL LUCENT
92100 Boulogne-Billancourt (FR)**

(72) Inventors:
• **Constantini, Carlo
23880 CASATENOVO (IT)**
• **Leven, Andreas
D-74321 BIETIGHEIM-BISSINGEN (DE)**
• **Cucchi, Silvio
20083 GAGGIANO (IT)**
• **Weisser, Stefan
D-90409 NUERNBERG (DE)**
• **Kaneda, Noriaki
WESTFIELD 07090 NJ (US)**
• **Rinaldi, Sonia
23030 VOLERO (IT)**

(74) Representative: **Shamsaei Far, Hassan et al
Alcatel-Lucent International
148/152 route de la Reine
92100 Boulogne-Billancourt (FR)**

(56) References cited:
**FR-A1- 2 785 747     US-A- 4 558 454
US-B1- 6 636 570**

• **SEB J SAVORY: "Digital filters for coherent
optical receivers" OPTICS EXPRESS, OSA
(OPTICAL SOCIETY OF AMERICA),
WASHINGTON DC, (US) LNKD-
DOI:10.1364/OE.16.000804, vol. 16, no. 2, 21
January 2008 (2008-01-21), pages 804-817,
XP007906766 ISSN: 1094-4087**

**Description**

**Technical Field**

The present invention relates to the field of digital data processing. In particular, the present invention relates to a parallel digital filter, in particular (but not exclusively) for a coherent optical receiver for an optical communication network.

**Background Art**

In a known optical communication network, digital data are typically transmitted in the form of modulated optical signals. In particular, the digital data to be transmitted are used for digitally modulating an optical carrier, i.e. one or more parameters (amplitude and/or phase and/or frequency) of the optical carrier are varied according to the digital data thereby generating a modulated optical signal. The modulated optical signal may be expressed by the following equation:

$$s(t)=A \cos(2\pi ft-\theta) = I \cos(2\pi ft) + Q \sin(2\pi ft), \qquad [1]$$

where $I= A \cos\theta$ is typically termed in-phase component, while $Q= A \sin\theta$ is typically termed quadrature component. A is the amplitude of the modulated optical signal, f is the frequency of the modulated optical signal, and $\theta$ is the phase of the modulated optical signal.

Different types of digital modulations are known, such as for instance phase modulations (PSK, DPSK, QPSK, etc.) wherein $\theta$ is varied according to the digital data to be transmitted, and amplitude-phase modulations (QAM, etc.) wherein both A and $\theta$ are varied according to the digital data to be transmitted.

Typically, digital data to be transmitted comprise a sequence of symbols, each symbol comprising a predefined number M of bits. Hence, a discrete set of $2^M$ possible symbols $S_i$ (i=1, ...$2^M$) may be transmitted.

According to a digital phase modulation, each possible symbol $S_i$ is biuniquely associated to a possible value $\theta_i$ of the phase $\theta$, and therefore to a value $I_i= A \cos\theta_i$ of the in-phase component I and to a value $Q_i= A \sin\theta_i$ of the quadrature component Q. Hence, each possible symbol $S_i$ may be represented in a Cartesian plane (hereinafter referred to as I-Q plane) as a point $(I_i, Q_i)$ whose Cartesian coordinates are $I_i= A \cos\theta_i$ and $Q_i= A \sin\theta_i$. The ensemble of the points $(I_i, Q_i)$ (i=1, ...$2^M$) is typically termed "constellation", and in the present description and in the claims will be termed "reference constellation". Since the amplitude A is constant, all the points $(I_i, Q_i)$ of the reference constellation lie on a circumference in the I-Q plane.

For instance, assuming that the modulated optical signal s(t) is modulated according to the known QPSK digital phase modulation, M=2 and accordingly the possible symbols $S_i$ are $2^2$=4, i.e. $S_1$=00, $S_2$=01, $S_3$=10, $S_4$=11. Such possible symbols $S_1$, $S_2$, $S_3$, $S_4$ are biuniquely associated to the values $\theta_1$=45°, $\theta_2$=135°, $\theta_3$=225° and $\theta_4$=315° of the phase $\theta$, respectively. Hence, the possible symbols $S_1$, $S_2$, $S_3$ and $S_4$ can be represented in the I-Q plane as the points $(\sqrt{2}/2, \sqrt{2}/2), (-\sqrt{2}/2, \sqrt{2}/2), (-\sqrt{2}/2, -\sqrt{2}/2)$ and $(\sqrt{2}/2, -\sqrt{2}/2)$, forming the reference constellation for QPSK.

At the reception side, the modulated optical signal s(t) is typically demodulated for retrieving the original digital data. A known receiver suitable for demodulating the modulated optical signal is the so-called "coherent optical receiver".

A coherent optical receiver typically comprises a local oscillator which generates a first demodulation optical carrier $\cos(2\pi ft)$ and a second demodulation optical carrier $\sin(2\pi ft)$ having frequency substantially equal to the frequency f of the modulated optical signal s(t).

The coherent optical receiver typically combines the received modulated optical signal s(t) with the first demodulation optical carrier $\cos(2\pi ft)$ and with the second demodulation optical carrier $\sin(2\pi ft)$, and usually performs a photoelectric conversion of the resulting optical signals, thereby deriving an in-phase component I' and an quadrature component Q' in the form of electrical signals. The components I' and Q' correspond to the components I and Q, except for noise and/or distortion introduced by propagation of the modulated optical signal and/or by the above operations performed by the optical coherent receiver.

Then, the coherent optical receiver typically performs an analog-to-digital conversion of the in-phase component I' and the quadrature component Q' by sampling them at a symbol rate, thereby providing in-phase samples $I'_k$ and corresponding quadrature samples $Q'_k$ (k being the sample index). Each couple of samples $(I'_k, Q'_k)$ may be represented in the I-Q plane as a point $(I'_k, Q'_k)$ whose Cartesian coordinates are $I'_k$ and $Q'_k$. In the present description and in the claims, the ensemble of the points $(I'_k, Q'_k)$ will be termed "received constellation". Due to the above mentioned noise and/or distortion, the points $(I'_k, Q'_k)$ of the received constellation typically form "clouds" whose barycentres may be displaced relative to the corresponding points $(I_i, Q_i)$ of the reference constellation.

Then, each point $(I'_k, Q'_k)$ is typically compared with all the points $(I_i, Q_i)$ of the reference constellation, for determining the closest one (i.e. the one having the minimum distance in the I-Q plane). The possible symbol Si corresponding to the closest among the points $(I_i, Q_i)$ of the reference constellation is then assumed to be the symbol actually transmitted.

Typically, the frequency of the first and second demodulation optical carriers $\cos(2\pi ft)$ and $\sin(2\pi ft)$ generated at the optical coherent receiver is slightly different from the frequency of the modulated optical signal s(t) received at the optical coherent receiver (the difference is typically of the order of magnitude of few ppm). As a consequence, the received constellation typically rotates in time relative to the reference constellation, i.e. the "clouds" rotate relative to the points $(I_i, Q_i)$ of the reference constellation. The rotation frequency of the received constellation is substantially equal to the difference between the frequency of the first and second demodulation carriers $\cos(2\pi ft)$ and $\sin(2\pi ft)$ and the frequency of the received modulated optical signal s(t).

Rotation of the received constellation is typically compensated by determining the rotation frequency and applying a counter-rotation to the received constellation, thereby substantially stopping rotation of the received constellation.

FR 2 785 747 discloses a digital filter with parallel architecture for use in a spread-spectrum signal receiver for processing an in-phase signal and a quadrature signal. The filter comprises a number P of shift registers with means for working out a weighted sum of the samples stored in the registers, thereby obtaining a number P of weighted sums which can be recombined. The number P can be equal to 2.

US 4 558 454 discloses a digital partial response filter applicable in an FM subcarrier (SCA) digital data transmission system wherein digital data is frequency modulated on an FM subcarrier. The partial response digital filter includes a digital memory wherein digitised samples of the partial response channel response to a representative input digital data symbol are stored and digital adding means for cumulatively summing the digitised samples in groups so as to produce the partial response channel response to an input digital data stream.

## Summary of the invention

After the received constellation is stopped, it may be disadvantageously still rotated by an arbitrary rotation angle $\alpha$ relative to the reference constellation. In other words, the "clouds" of the received constellation may still be not centred on the corresponding points $(I_i, Q_i)$ of the reference constellation. Further, in spite of the counter-rotation, the rotation angle $\alpha$ may slowly vary in time. This may disadvantageously worsen the performance of the optical coherent receiver, since it can induce errors when each point $(I'_k, Q'_k)$ of the received constellation is compared with all the points $(I_i, Q_i)$ of the reference constellation for determining the closest one.

Therefore, also the rotation of the received constellation relative to the reference constellation by the slowly-varying rotation angle $\alpha$ should be compensated. This may be implemented by estimating the rotation angle $\alpha$ and by rotating each point $(I'_k, Q'_k)$ of the received constellation by $-\alpha$.

Estimation of the rotation angle $\alpha$ may be performed according to the known Viterbi and Viterbi algorithm.

According to the Viterbi and Viterbi algorithm, each couple of samples $(I'_k, Q'_k)$ is converted into a corresponding angular sample $\theta'_k$. Then, the angular sample $\theta'_k$ is multiplied by $2^M$. This allows bringing all the angular samples $\theta'_k$ into a same quadrant of the I-Q plane. Then, each multiplied angular sample is converted into its complex components, thereby providing a real sample $X_k = \cos(2^M \cdot \theta'_k)$ and an imaginary sample $Y_k = \sin(2^M \cdot \theta'_k)$. Then, a real average XAV is calculated on a number of consecutive real samples $X_k$, while an imaginary average YAV is calculated on the corresponding imaginary samples $Y_k$. The averages XAV and YAV are then converted into a corresponding average multiplied angle, which is then divided by $2^M$, thereby deriving an average angle $\theta'_{AV}$. The average angle $\theta'_{AV}$ is then compared with the possible values $\theta_i$ of the phase $\theta$ for determining the closest one. Finally, the rotation angle $\alpha$ is estimated as the difference between the average angle $\theta'_{AV}$ and the closest one among the possible values $\theta_i$ of the phase $\theta$.

In principle, the rotation angle $\alpha$ may be periodically estimated, for instance with a period T larger than the symbol period. The resulting estimate of the rotation angle $\alpha$ may then be applied to all the couples of samples $(I'_k, Q'_k)$ received during the period T, by subtracting it from all the corresponding angular samples $\theta'_k$.

However, this solution disadvantageously does not allow compensating the rotation of the received constellation with a sufficient accuracy. Indeed, according to this solution the estimate rotation angle is kept constant over a whole period T. However, the rotation angle $\alpha$ is typically not constant over a period T because, as mentioned above, it typically slowly varies in time in a continuous manner. Hence, the above solution provides an accurate compensation only on the couple of samples $(I'_k, Q'_k)$ received at half of the period T. For couples of samples $(I'_k, Q'_k)$ received at instants with increasing distances from the half, the accuracy of the compensation disadvantageously decreases.

A more accurate compensation may be achieved by estimating the rotation angle $\alpha$ at each symbol period. In particular, a more accurate compensation may be achieved by calculating the averages XAV and YAV at each symbol period as moving averages on L couples of samples $(I'_k, Q'_k)$ (L being an odd integer equal to or higher than 3), one of the L couples of samples ($I'_k$, $Q'_k$) being the currently received one. The resulting estimation of the rotation angle $\alpha$ is then applied only to the currently received couple of samples ($I'_k$, $Q'_k$). Herein after, for simplicity, reference will be made only to the real average XAV. However, the same considerations also apply to the imaginary average YAV.

The operation of calculating the real average XAV at each symbol period as a moving average may be expressed by the following equation:

$$XAV_k = \frac{1}{L} \cdot \sum_{j=k-L+1}^{k} X_j \, . \qquad [2]$$

A particular accurate estimate of the rotation angle $\alpha$ may be achieved if the real average $XAV_k$ is calculated on the currently received couple ($I'_k$, $Q'_k$), (L-1)/2 couples preceding the currently received one ($I'_k$, $Q'_k$), and (L-1)/2 couples following the currently received one ($I'_k$, $Q'_k$).

The operation of equation [2] may be implemented by a digital filter having the following transfer function:

$$H(z) = 1 + z^{-1} + z^{-2} + \ldots z^{L-1}, \qquad [3]$$

the multiplication by 1/L being omitted for simplicity.

The inventors have noticed that, typically, the analog-to-digital converters of the optical coherent receiver, which sample the components I' and Q' thereby providing at their outputs the couples ($I'_k$,$Q'_k$), are connected to the digital portion of the coherent optical receiver by means of parallel buses supporting simultaneous transmission of a number N of couples ($I'_k$, $Q'_k$) at each clock period of a clock signal synchronizing operation of the receiver. Such clock period is much larger than a symbol period. N may be equal for instance to 64, 128, 256, etc. Successive digital processing of the couples ($I'_k$, $Q'_k$) within the digital portion of the receiver is then typically performed according to a parallel scheme, i.e. at each clock cycle the digital portion simultaneously performs a same operation on N data.

Hence, also the compensation of the rotation angle $\alpha$ should be performed according to a parallel scheme. Therefore, the digital filter having the transfer function [3] should be capable of receiving in parallel N real samples $X_k$ at each clock cycle, and output in parallel N real moving averages $XAV_k$ at each clock cycle.

The inventors have noticed that such a digital filter is very difficult to implement. Indeed, while implementing a digital filter having the transfer function [3] does not exhibit particular design issues when the digital filter operates serially (i.e. in a clock cycle it receives a single real sample and outputs a single real average), complex design issues may arise in case of parallel operation. Indeed, the complexity of the digital filter (namely, the number of components such as adders and delay elements comprised therein) may be disadvantageously very high, especially when N is equal to 64, 128, 256 or a higher value.

In view of the above, the inventors have tackled the problem of providing a digital filter (in particular, but not exclusively, for a coherent optical receiver) which is capable of performing the operation described by the above equation [2] according to a parallel scheme, i.e. that is capable, at each clock cycle, of simultaneously receiving a number N of samples $X_k$ and simultaneously outputting a same number N of moving averages $XAV_k$, each of the N moving averages $XAV_k$ being calculated on L consecutive samples according to the above equation [2].

According to a first aspect, the present invention provides a digital filter configured to receive a sequence of digital samples, the digital filter being configured to receive in parallel N digital samples of the sequence at each clock cycle of a clock signal suitable for synchronizing operation of the digital filter, N being an integer higher than 1, and to calculate a sum of L consecutive digital samples of the sequence, L being an odd integer equal to or higher than 3 and lower than N, the digital filter comprising:

- an integrating circuit configured to calculate a first integral of the sequence up to a first digital sample of the L consecutive digital samples and a last integral of the sequence up to a last digital sample of the L consecutive digital samples; and
- a differentiating circuit configured to calculate the sum as a difference between the last integral and the first integral,

wherein the integrating circuit comprises a cumulative sum module, an addition module connected to the cumulative sum module and a first register retroactively connected to the addition module, wherein:

- the cumulative sum module is configured to calculate a last cumulative sum of the last digital sample and preceding digital samples of the sequence received within a same clock cycle as the last digital sample;

- the first register is configured to store a delayed integral calculated on digital samples of the sequence received before the same clock cycle; and
- the addition module is configured to calculate the last integral by adding the last cumulative sum and the delayed integral.

Preferably, the cumulative sum module is configured to receive in parallel N digital samples of the sequence of digital samples in the same clock cycle, and to provide N cumulative sums in parallel, the N cumulative sums including the last cumulative sum.

Preferably, the addition module is configured to receive in parallel the N cumulative sums and to add the delayed integral to each of the N cumulative sums, thereby providing in parallel N currently calculated integrals, the N currently calculated integrals including the last integral.

Preferably, the first register is configured to:

- before receiving the N currently calculated integrals, storing N previously calculated integrals, the N previously calculated integrals including the delayed integral and the first integral; and
- receive from the addition module the N currently calculated integrals and store them, thereby overwriting the N previously calculated integrals.

Preferably, the differentiating circuit comprises a second register cooperating with the first register, and the first register is configured to, upon reception of the N currently calculated integrals, forward the N previously calculated integrals to the second register, before overwriting them.

Preferably, the differentiating circuit further comprises a first selector and a second selector connected to the first register and the second register, and:

- the first selector is configured to read from the first register and the second register N minuend integrals selected among the N previously calculated integrals and the N currently calculated integrals, the N minuend integrals including the last integral; and
- the second selector is configured to read from the first register and the second register N subtrahend integrals selected among the N previously calculated integrals and the N currently calculated integrals, the N subtrahend integrals including the first integral, wherein the N minuend integrals are shifted by L-1 relative to the N subtrahend integrals.

Preferably:

- the N minuend integrals are a concatenation of the last $(N/2)-((L-1)/2)$ integrals of the N previously calculated integrals and the first $(N/2)+((L-1)/2)$ integrals of the N currently calculated integrals; and
- the N subtrahend integrals are a concatenation of the last $(N/2)+((L-1)/2)$ integrals of the N previously calculated integrals and the first $(N/2)-((L-1)/2)$ integrals of the N currently calculated integrals.

Preferably, the differentiating circuit further comprises a second addition module connected to the first selector and the second selector, the second addition module being configured to calculate N differences between the N minuend integrals and the N subtrahend integrals, the N differences including the difference between the last integral and the first integral.

According to advantageous variants, the cumulative sum module comprises $\log_2(N)-1$ further cumulative sum modules nested one in the other.

Preferably:

- the cumulative sum module comprises N/2 input adders, $(N/2)-1$ output adders and a first further cumulative sum module interposed between the N/2 input adders and the $(N/2)-1$ output adders; and
- the first further cumulative sum module comprises N/4 first further input adders, $(N/4)-1$ first further output adders and a second further cumulative sum module interposed between the N/4 first further input adders and the $(N/4)-1$ first further output adders.

Preferably, the further cumulative sum modules include an innermost further cumulative sum module in turn comprising a single adder.

Alternatively, the cumulative sum module comprises N cascaded adders.

According to a second aspect, the present invention provides a rotation compensator for an optical coherent receiver configured to receive a modulated optical signal, process the modulated optical signal for generating an in-phase component and a quadrature component, and sample the in-phase component and the quadrature component for generating couples of samples of the in-phase component and the quadrature component, the couples of samples forming a received constellation that is rotated relative to a reference constellation by a rotation angle, the rotation compensator comprising:

- a first angle module configured to receive in parallel N couples of samples and to convert them in N corresponding angular samples;
- an estimating circuit configured to process the N corresponding angular samples for estimating N rotation angles;
- a compensating circuit configured to apply the N rotation angles to the N corresponding angular samples, thereby providing N compensated angular samples; and
- a first sine-cosine module configured to receive the N compensated angular samples in parallel and to convert them in N corresponding couples of compensated samples,

wherein the estimating circuit comprises a digital filter as set forth above.

According to a third aspect, the present invention provides a coherent optical receiver for an optical communication network configured to receive a modulated optical signal and to process the modulated optical signal for generating an in-phase component and a quadrature component, the coherent optical receiver comprising a rotation compensator as set forth above.

According to a fourth aspect, the present invention provides an optical communication network comprising an optical coherent receiver as set forth above.

### Brief description of the drawings

Embodiments of the invention will be better understood by reading the following detailed description, given by way of example and not of limitation, to be read with reference to the accompanying drawings, wherein:

- Figure 1 is a block diagram of a coherent optical receiver according to a preferred embodiment of the present invention;
- Figure 2 is a block diagram of the rotation compensator comprised in the coherent optical receiver of Figure 1, according to a preferred embodiment of the present invention;
- Figure 3 is a block diagram of one of the digital filters comprised in the rotation compensator of Figure 2;
- Figure 4 is a block diagram of a possible implementation of an integrating circuit;
- Figure 5 is a block diagram of the cumulative sum module comprised in the digital filter of Figure 3 according to a first variant, in an exemplary case where N=8;
- Figure 6 is a block diagram of the cumulative sum module comprised in the digital filter of Figure 3 according to a second variant, in an exemplary case where N=8; and
- Figures 7a and 7b schematically show the operation of the differentiating circuit comprised in the digital filter of Figure 3, when the length of the digital filter is L=3 and L=5, respectively.

### Detailed description of preferred embodiments of the invention

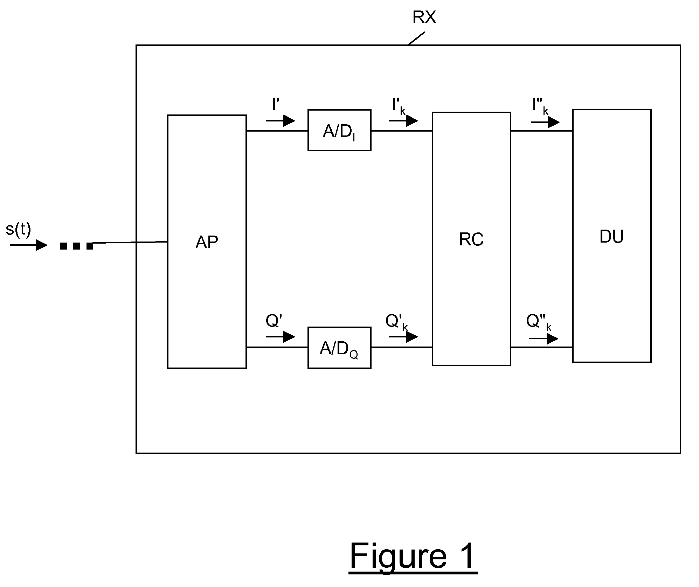

Figure 1 schematically shows a coherent optical receiver RX according to a preferred embodiment of the present invention.

The coherent optical receiver RX preferably comprises an analog portion AP, an in-phase analog-to-digital converter $A/D_I$, a quadrature analog-to-digital converter $A/D_Q$, a rotation compensator RC and a decision unit DU. The coherent optical receiver RX may comprise further modules, that are not shown in Figure 1 and will not be described since they are not relevant to the present description.

The analog portion AP preferably has an input substantially corresponding to the input of the coherent optical receiver RX, and two outputs. The analog portion AP is preferably implemented as an arrangement of optical, electrical and electro-optical components. The physical implementation of the analog portion AP will not be described in detail, since it is not relevant to the present description.

Preferably, the in-phase analog-to-digital converter $A/D_I$ and the quadrature analog-to-digital converter $A/D_Q$ are connected to the outputs of the analog portion AP. The outputs of the in-phase analog-to-digital converter $A/D_I$ and the quadrature analog-to-digital converter $A/D_Q$ are preferably connected to the inputs of the rotation compensator RC. The decision unit DU has two inputs, which are preferably connected to the outputs of the rotation compensator RC. The connections between outputs of the analog-to-digital converters $A/D_I$, $A/D_Q$ and inputs of the rotation compensator RC are preferably implemented as parallel buses. Similarly, the connections between outputs of the rotation compensator RC and inputs of the decision unit DU are preferably implemented as parallel buses.

When a modulated optical signal $s(t)=A \cos(2\pi ft-\theta)$ is received at the input of the optical coherent receiver RX, the analog portion AP preferably processes it for generating an in-phase component I' and a quadrature component Q' basically corresponding (except for noise and/or distortions introduced by propagation and/or by the analog portion AP itself) to the components I and Q of the modulated optical signal s(t). Both the in-phase component I' and the quadrature component Q' output by the analog portion AP are preferably in the form of analog electrical signals. The operation of the analog portion AP will not be described in further detail, since it is not relevant to the present description.

Then, according to this first embodiment, the in-phase analog-to-digital converter $A/D_I$ preferably samples the in-phase component I', thereby generating a sequence of in-phase component samples $I'_k$. Substantially at the same time, the quadrature analog-to-digital converter $A/D_Q$ preferably samples the quadrature component Q', thereby generating a sequence of quadrature component samples $Q'_k$. Herein after, for simplicity, it is assumed that the sampling is performed at the symbol rate, so that each couple of samples $(I'_k, Q'_k)$ correspond to a respective received symbol.

As mentioned above, the couples of samples $(I'_k, Q'_k)$ may be represented in the I-Q plane as points $(I'_k, Q'_k)$ forming the received constellation, that is typically rotated relative to the reference constellation by a slowly varying rotation angle $\alpha$.

Preferably, the rotation compensator RC compensates such rotation according to the above mentioned known Viterbi and Viterbi algorithm, as it will be described in detail herein after, thereby providing at its output couples of compensated samples $(I''_k, Q''_k)$. The couples of compensated samples $(I''_k, Q''_k)$ may be represented in the I-Q plane as points $(I''_k, Q''_k)$ forming a compensated received constellation, that advantageously overlap with the reference constellation (i.e. the "clouds" of the compensated received constellation are substantially centered around respective points of the reference constellation).

Then, the rotation compensator RC preferably forwards the couples of compensated samples $(I''_k, Q''_k)$ to the decision unit DU, that processes them for retrieving the digital data originally transmitted. The operation of the decision unit DU depends on the type of digital modulation applied to the modulated optical signal s(t), and will not be described in further detail, since it is not relevant to the present description.

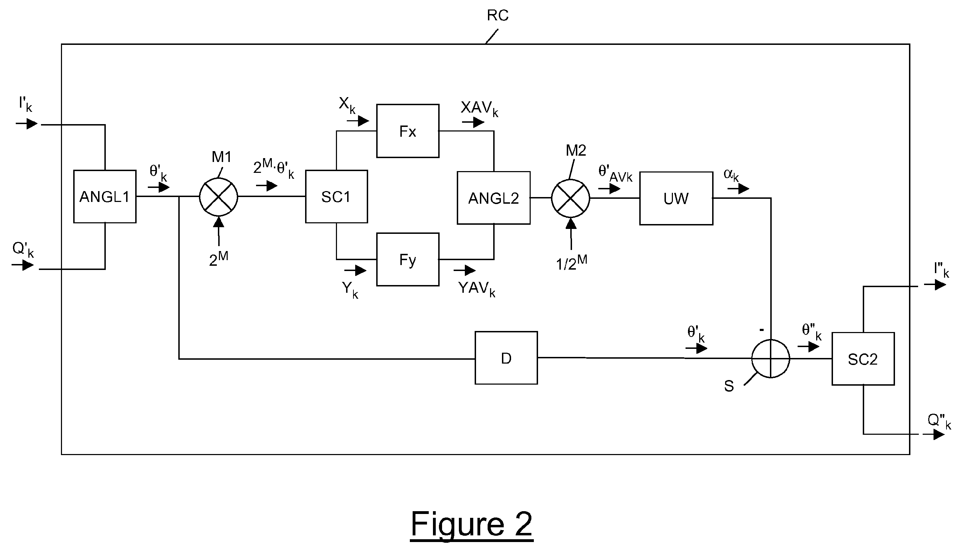

With reference to Figure 2, the rotation compensator RC according to a preferred embodiment of the present invention will be now described in detail.

The rotation compensator RC preferably comprises a first angle module ANGL1, a first multiplier M1, a first sine-cosine module SC1, a first digital filter Fx, a second digital filter Fy, a second angle module ANGL2, a second multiplier M2, an unwrapper UW, an adder S, a delay line D and a second sine-cosine module SC2.

The first angle module ANGL1 preferably has two inputs corresponding to the inputs of the rotation compensator RC, and an output connected to the input of the first multiplier M1. The output of the first multiplier M1 is preferably connected to the input of the first sine-cosine module SC1. The first sine-cosine module SC1 preferably has two outputs, one connected to the input of the first digital filter Fx and the other connected to the input of the second digital filter Fy. The outputs of both the first digital filter Fx and second digital filter Fy are preferably connected to the input of the second angle module ANGL2. The output of the second angle module ANGL2 is preferably connected to the input of the second multiplier M2. The output of the second multiplier M2 is preferably connected to the input of the unwrapper UW. The input of the delay line D is preferably connected to the output of the first angle module ANGL1. The outputs of the delay line D and of the unwrapper UW are preferably connected to the inputs of the adder S. The output of the adder S is preferably connected to the input of the second sine-cosine module SC2. The second sine-cosine module SC2 has two outputs, that basically correspond to the outputs of the rotation compensator RC.

The rotation compensator RC preferably comprises also a clock input suitable for receiving a clock signal from a clock unit (not shown in Figure 1) comprised within the optical coherent receiver RX.

The operation of the rotation compensator RC according to a preferred embodiment of the present invention will be now described in detail.

Preferably, at each clock cycle of the above mentioned clock signal, the rotation compensator RC preferably receives in parallel (i.e. substantially simultaneously) N couples of samples $(I'_k, Q'_k)$, N being an integer equal to or higher than 2. For instance, N may be equal to 8, 16, 32, 64, 128, etc. The first sine-cosine module SC1 preferably converts the N couples of samples $(I'_k, Q'_k)$ in N corresponding angular samples $\theta'_k$. Then, preferably, the first multiplier M1 multiplies each of the N angular samples $\theta'_k$ by $2^M$, thereby bringing all the N angular samples $\theta'_k$ into a same quadrant of the I-Q plane.

Then, the first sine-cosine module SC1 preferably converts each of the N multiplied angular samples $2^M \cdot \theta'_k$ into its respective real and imaginary components, thereby providing N real samples $X_k = \cos(2^M \cdot \theta'_k)$ and N imaginary samples $Y_k = \sin(2^M \cdot \theta'_k)$.

The N real samples $X_k = \cos(2^M \cdot \theta'_k)$ are forwarded to the first digital filter Fx, that preferably calculates N real averages $XAV_k$, each of the N real averages $XAV_k$ being calculated on a number L (L being equal to or higher than 3) of consecutive real samples, as it will be described in detail herein after. Substantially at the same time, the N imaginary samples $Y_k = \sin(2^M \cdot \theta'_k)$ are forwarded to the second digital filter Fy, that preferably calculates N imaginary averages $YAV_k$, each of the N imaginary averages $YAV_k$ being calculated on the same number L of consecutive imaginary samples, as it will be described in detail herein after.

The N real averages $XAV_k$ and the N imaginary averages $YAV_k$ are then forwarded to the second angle module ANGL2, that preferably converts them in N corresponding angles. Then, the second multiplier M2 preferably divides such N corresponding angles by $2^M$, thereby providing N average angles $\theta'_{AVK}$. Then, preferably, the unwrapper UW compares each of the N average angles $\theta'_{AVK}$ with the possible values $\theta_i$ of the phase $\theta$ for determining the closest one, and estimates N rotation angles $\alpha_k$ as the difference between the average angle $\theta'_{AVk}$ and the closest one among the possible values $\theta_i$ of the phase $\theta$.

Then, the adder S preferably receives the N angular samples $\theta'_k$ (suitably delayed by the delay line D) and the N rotation angles $\alpha_k$, and calculates N compensated angular samples $\theta''_k$ by subtracting from each angular samples $\theta'_k$ the corresponding rotation angle $\alpha_k$. The N compensated angular samples $\theta''_k$ are then forwarded to the second sine-cosine module SC2, that preferably converts each of the N compensated angular samples $\theta''_k$ into its respective real and imaginary components, thereby providing N couples of compensated samples ($I''_k$, $Q''_k$), where $I''_k=\cos(\theta''_k)$ are N compensated in-phase samples and $Q''_k=\sin(\theta''_k)$ are N compensated quadrature samples.

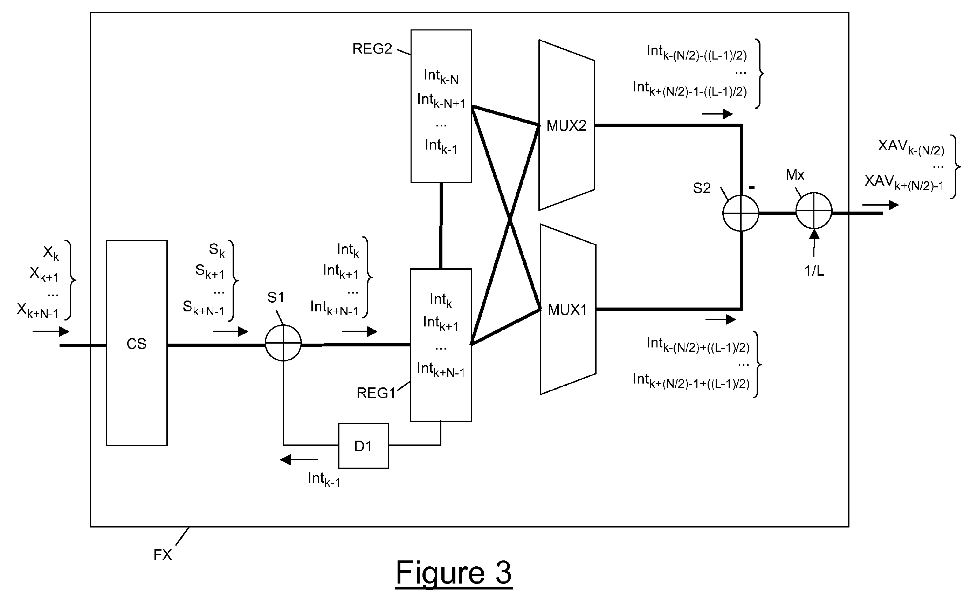

With reference to Figure 3, the first digital filter Fx will be now described in further detail. The second digital filter Fy substantially has the same structure and operation as the first digital filter Fx. Hence, a detailed description will be provided herein after only for the first digital filter Fx. For simplicity, the first digital filter Fx will be briefly termed in the following description "digital filter".

As mentioned above, at each clock cycle the digital filter Fx preferably receives N real samples $X_k$ and provides at its output N real averages $XAV_k$. according to the following operation (see above equation [2]):

$$XAV_k = \frac{1}{L} \cdot \sum_{j=k-L+1}^{k} X_j \, . \tag{2}$$

Accordingly, the digital filter Fx preferably has the following transfer function (see above equation [3]):

$$H(z) = 1 + z^{-1} + z^{-2} + \ldots z^{L-1}, \tag{3}$$

the multiplication by 1/L being omitted for simplicity.

The inventors have noticed that a known factorization may be applied to the transfer function of equation [3], thereby dividing it into a first transfer function:

$$H1(z) = \frac{1}{1 - z^{-1}} \tag{4}$$

and a second transfer function:

$$H2(z) = 1 - z^{-L} \, . \tag{5}$$

Hence, the digital filter Fx may be implemented as a cascade of an integrating circuit having transfer function H1 (z) and hence performing the following operation:

$$Int_k = \sum_{j=-\infty}^{k} X_j \, , \tag{6}$$

a differentiating circuit having transfer function H2(z) and hence performing the following operation:

$$Int_k - Int_{k-L+1} \tag{7}$$

and a multiplier by 1/L performing the following operation:

$$XAV_k = \frac{1}{L} \cdot (Int_k - Int_{k-L+1})$$ [8]

If the operation of equation [2] has to be performed not on the current sample and the L-1 preceding samples, but on the current sample, the (L-1)/2 preceding samples and the (L-1)/2 successive samples (i.e. the moving average should be centred on the current sample), equation [7] is:

$$Int_{k+((L-1)/2)} - Int_{k-((L-1)/2)} \,,$$ [7']

and therefore equation [8] is:

$$XAV_k = \frac{1}{L} \cdot \left(Int_{k+((L-1)/2)} - Int_{k-((L-1)/2)}\right)$$ [8']

Figure 3 schematically shows the structure of the digital filter Fx implemented substantially as a cascade of the above integrating circuit, the above differentiating circuit and a multiplier by 1/L.

More particularly, the digital filter Fx preferably comprises a cumulative sum module CS, a first addition module S1, a delay element D1, a first register REG1, a second register REG2, a first selector MUX1, a second selector MUX2, a second addition module S2 and a multiplication module Mx.

The input of the cumulative sum module CS basically corresponds to the input of the digital filter Fx. The output of the cumulative sum module CS is preferably connected to one of the inputs of the first addition module S1. The output of the first addition module S1 is preferably connected to the input of the first register REG1. The first register REG1 has an output connected to the other input of the first addition module S1 via the delay element D1, according to a feedback configuration. Further, preferably, the first register REG1 is connected to the second register REG2. The outputs of the first and second registers REG1, REG2 are preferably connected to the inputs of the first and second selectors MUX1, MUX2, respectively. The outputs of the first and second selectors MUX1, MUX2 are preferably connected to the inputs of the second addition module S2. The input of the multiplication module Mx is preferably connected to the output of the second addition module S2. The output of the multiplication module Mx preferably corresponds to the output of the digital filter Fx. The bold lines in Figure 3 preferably indicate parallel connections, i.e. connections capable of transporting N data in parallel.

When, at a given clock cycle, the digital filter Fx receives N samples $X_k$, $X_{k+1}$, ... $X_{k+N}$-1 from the first sine-cosine module SC1, the cumulative sum module CS preferably calculates N cumulative sums as follows:

$$S_k = x_k;$$

$$S_{k+1} = x_k + x_{k+1};$$

$$\ldots$$

$$S_{k+N-1} = x_k + x_{k+1} + x_{k+2} + \ldots + x_{k+N-1}.$$

The cumulative sum module CS then preferably forwards the N cumulative sums $S_k$, $S_{k+1}$, ... $S_{k+N-1}$ to the first addition module S1. Substantially at the same time, the first addition module S1 receives from the delay element D1 a delayed integral $Int_{k-1}$ that was calculated by the first addition module S1 on the N samples received at the previous clock cycle and that was stored in the first register REG1.

The first addition module S1 then preferably adds the delayed integral $Int_{k-1}$ to each of the N cumulative sums $S_k$, $S_{k+1}$, ... $S_{k+N-1}$, thereby providing at its output the following N integrals:

$$Int_k = Int_{k-1} + S_k;$$

$$Int_{k+1} = Int_{k-1} + S_{k+1};$$

$$\ldots$$

$$Int_{k+N-1} = Int_{k-1} + S_{k+N-1}.$$

The N integrals are then forwarded to the first register REG1, that preferably stores them, thereby overwriting N integrals $Int_{k-N}$, $Int_{k-N+1}$, ... $Int_{k-1}$ calculated by the first addition module S1 on the N samples received at the previous clock cycle.

It can be noticed that the cumulative sum module CS, the first addition module S1, the first register REG1 and the delay element D1 basically form an integrating circuit performing the integrating operation defined by the above equation [6]. In particular, the integrating operation is performed in two steps. Instead of calculating, for each sample $X_k$, $X_{k+1}$, ... $X_{k+N-1}$, the integral on all the previous samples (including the ones received during preceding clock cycles) as provided by equation [6], for each sample $X_k$, $X_{k+1}$, ... $X_{k+N-1}$ the cumulative sum block CS firstly calculates a "partial integral" (i.e. the cumulative sums $S_k$, $S_{k+1}$, ... $S_{k+N-1}$) only on the samples received during the current clock cycle. Afterwards, the first addition module S1 shifts all the partial integrals by a same amount (i.e. the delayed integral $Int_{k-1}$) that basically is the integral calculated on all the samples received during the preceding clock cycles, i.e. received before the N currently received ones.

This two-step implementation is advantageous, since the N integrals $Int_k$, $Int_{k+1}$, ... $Int_{k+N-1}$ may be advantageously calculated in more than one clock cycle.

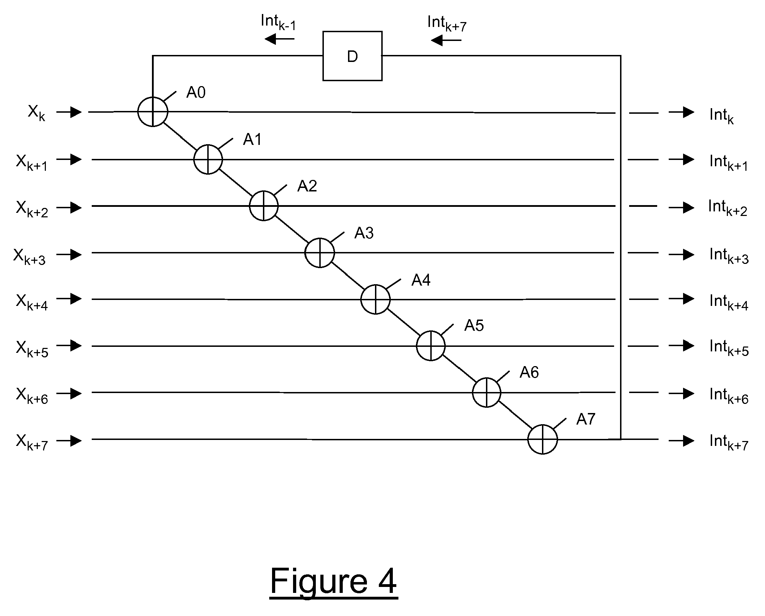

Indeed, in principle the most straightforward solution for directly implementing the above operation [6] would be the circuit shown in Figure 4. For simplicity, it is assumed that N=8. The circuit comprises N=8 cascaded adders A0, A1, ... A7 and a delay block D forming a feedback loop between the first adder A0 and the last adder A7. At a first clock cycle, the circuit receives N=8 samples $X_0$, $X_1$, ... $X_7$. The adder A0 provides $Int_0$ equal to $X_0$, and then the other adders A1, ... A7 operate in cascade for calculating the other integrals $Int_1$, ... $Int_7$ according to equation [6]. The last integral $Int_7$ is then sent to the delay block D. At the next clock cycle, the circuit receives N=8 other samples $X_8$, $X_9$, ... $X_{15}$ and the last integral $Int_7$ from the delay block D. The first adder A0 sums $X_8$ with $Int_7$ for calculating $I_8$, and then the other adders A1, ... A7 operate in cascade for calculating the other integrals $Int_9$, ... $Int_{15}$ according to equation [6]. In general, in the circuit of Figure 4, at each clock cycle N=8 new samples $X_k$, $X_{k+1}$, ... $X_{k+7}$ are received and, for calculating the corresponding N=8 integrals $Int_k$, $Int_{k+1}$, ... $Int_{k+7}$, the integral $Int_{k-1}$ must be available at the beginning of the current clock cycle. Similarly, for allowing proper operation of the circuit at the next clock cycle, the integral $Int_{k+7}$ must be available at the beginning of the next clock cycle. In other words, all the integrals $Int_k$, $Int_{k+1}$, ... $Int_{k+7}$ must be calculated in a single clock cycle. However, in an optical communication system a clock cycle is of few nanoseconds. Therefore, the cascaded operation of the N=8 adders should be completed within few nanoseconds. However, the current implementation of adders allows no more than 2-3 adders to operate in cascade in such a short time. The circuit of Figure 4 is therefore not capable of calculating all the integrals $Int_k$, $Int_{k+1}$, ... $Int_{k+7}$ in a single clock cycle.

The two-step implementation of the integrating operation defined by equation [6] advantageously removes the constraint of calculating the N integrals $Int_k$, $Int_{k+1}$, ... $Int_{k+N-1}$ corresponding to the N currently received samples $X_k$, $X_{k+1}$, ... $X_{k+N-1}$ within the current clock cycle. Indeed, at each clock cycle, the cumulative sum module CS receives N samples $X_k$, $X_{k+1}$, ... $X_{k+N-1}$ and may start calculating the corresponding cumulative sums $S_k$, $S_{k+1}$, ... $S_{k+N-1}$ without receiving any information derived from the N samples received during the previous clock cycle, because the cumulative sums $S_k$, $S_{k+1}$, ... $S_{k+N-1}$ are calculated only on the N currently received samples. The processing of the N samples received at the previous clock cycle may therefore still be running (i.e. the calculation of the N integrals corresponding to the N samples received at the previous clock cycle may be not completed yet), since none of these integrals is needed for starting calculation of the cumulative sums $S_k$, $S_{k+1}$, ... $S_{k+N-1}$. The only requirement is that the integral $Int_{k-1}$ is available when the calculation of the cumulative sums $S_k$, $S_{k+1}$, ... $S_{k+N-1}$ by the cumulative sums block CS is finished, so that the first addition module S1 may add it to the cumulative sums $S_k$, $S_{k+1}$, ... $S_{k+N-1}$ for obtaining the integrals $Int_k$, $Int_{k+1}$, ... $Int_{k+N-1}$. Therefore, advantageously, the calculation of the cumulative sums $S_k$, $S_{k+1}$, ... $S_{k+N-1}$ and therefore of the integrals $Int_k$, $Int_{k+1}$, ... $Int_{k+N-1}$ may take more than one clock cycle.

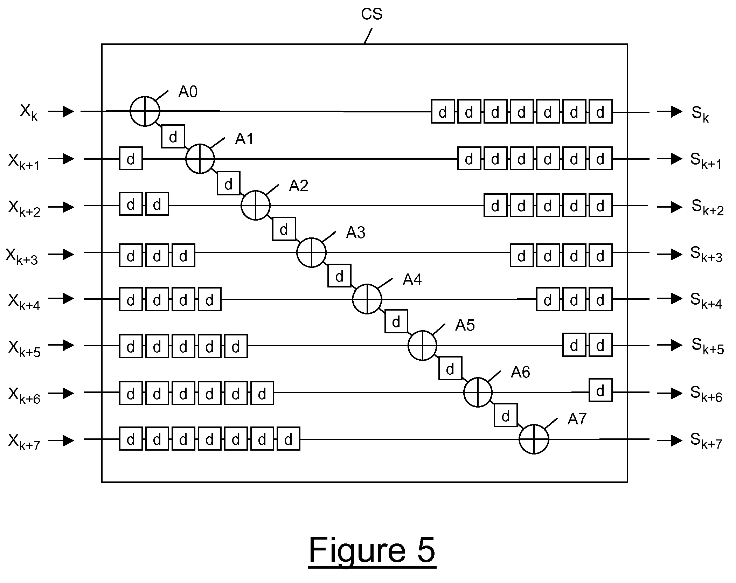

Figure 5 schematically shows the cumulative sum module CS according to a first variant of the present invention, in an exemplary case where N=8.

Similarly to the circuit of Figure 4, the cumulative sum module CS comprises N=8 cascaded adders A0, A1, ... A7. However, differently from the circuit of Figure 4, the cumulative sum module CS does not comprise any feedback loop between the first adder A0 and the last adder A7. At each clock cycle the cumulative sum module CS receives N=8 samples $X_k$, $X_{k+1}$, ... $X_{k+7}$. The first adder A0 preferably provides at the output of the cumulative sum module CS a first

cumulative sum $S_k=X_k$. The other adders A1, ... A7 preferably then operate in cascade, thereby providing the other cumulative sums $S_{k+1}$, ... $S_{k+7}$.

The whole operation may advantageously take multiple clock cycles. For instance, assuming that each adder performs a sum in a clock cycle, during a first clock cycle N=8 samples $X_k$, $X_{k+1}$, ... $X_{k+7}$ are received, and the first adder A0 calculates the cumulative sum $S_k=X_k$. During a second clock cycle, the second adder A1 calculates the cumulative sum $S_{k+1}=X_k+X_{k+1}$, while N=8 further samples $X_{k+8}$, $X_{k+9}$, ... $X_{k+15}$ are received and the first adder A0 calculates the cumulative sum $S_{k+8}=X_{k+8}$. During a third clock cycle, the third adder A2 calculates the cumulative sum $S_{k+2}=X_k+X_{k+1}+X_{k+2}$, the second adder A1 calculates the cumulative sum $S_{k+9}=X_{k+8}+X_{k+9}$, while N=8 further samples $X_{k+16}$, $X_{k+17}$, ... $X_{k+23}$ are received and the first adder A0 calculates the cumulative sum $S_{k+16}=X_{k+16}$. And so on. At the eighth clock cycle, the last adder A7 calculates the cumulative sum $S_{k+7}= X_k+ X_{k+1}+ ... X_{k+N-1}$. The cumulative sums $S_k$, $S_{k+1}$, $S_{k+2}$, ..., $S_{k+7}$ calculated on the N=8 samples $X_k$, $X_{k+1}$, ... $X_{k+7}$ received at the first clock cycle are then finally output in parallel by the cumulative sum module CS, while the processing of the N=8 samples received at the second, third, .... eight clock cycle is still in progress.

For implementing the above described cascaded operation (in particular, for synchronizing the inputs and outputs of the adders), the cumulative sum module CS preferably comprises a number of delay blocks d suitably distributed at the inputs of the adders A0, A1, ..., A7, at the output of the adders A0, A1, ... A7 and between each couple of consecutive adders A0, A1, ... A7, as schematically shown in Figure 5.

In particular, if N is the number of samples received at each clock cycle (and therefore N is the number of cascaded adders comprised in the cumulative sum module CS), assuming that each adder performs a sum in a clock cycle and that each delay block d introduces a delay of a single clock cycle, the overall number of delay blocks d preferably is $N^2-1$. In the exemplary case shown in Figure 5, where N=8, the overall number of delay blocks d is $(8^2-1)=63$. More generally, if a number R (R<N) of the N adders can operate in cascade within a single clock cycle, a single delay block d is needed at the output of the cascade of R adders. Then, the overall number of delay blocks d preferably is about equal to $N^2/R$. In any case, the complexity of the cumulative sum module CS shown in Figure 5 increases substantially proportionally to $N^2$.

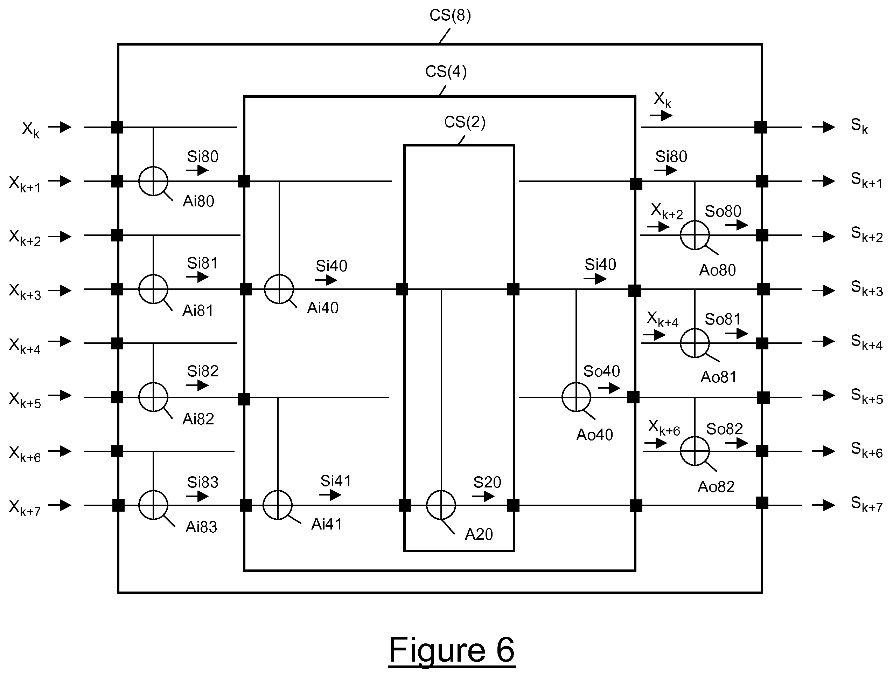

Figure 6 schematically shows the cumulative sum module according to a second variant of the present invention, in an exemplary case where N=8.

According to this second variant, a cumulative sum module CS(N) suitable for receiving N samples in parallel preferably comprises N/2 input adders, (N/2)-1 output adders and a nested cumulative sum module CS(N/2) interposed between the N/2 input adders and the (N/2)-1 output adders. Similarly, the nested cumulative sum module CS(N/2) preferably comprises N/4 input adders, (N/4)-1 output adders and a nested cumulative sum module CS(N/4) interposed between the N/4 input adders and the (N/4)-1 output adders. And so on. The cumulative sum module CS(N) preferably comprises $\log_2(N)-1$ cumulative sum modules nested one in the other. The innermost cumulative sum module CS(2) preferably comprises a single adder.

Figure 6 shows a cumulative sum module according to the second variant, where N=8 by way of example. Hence, the cumulative sum module CS(8) comprises 4 input adders Ai80, Ai81, Ai82, Ai83, 3 output adders Ao80, Ao81, Ao82 and a nested cumulative sum module CS(4). The cumulative sum module CS(4) preferably comprises 2 input adders Ai40 and Ai41, 1 output adder Ao40 and a nested cumulative sum module CS(2), that is also the innermost one. The cumulative sum module CS(2) preferably comprises a single adder A20.

According to this second variant, the cumulative sum module CS(N) has N inputs and N outputs, the cumulative sum module CS(N/2) has N/2 inputs and N/2 outputs, and so on. The innermost cumulative sum module CS(2) preferably has 2 inputs and 2 outputs.

The N inputs of the N/2 input adders of the cumulative sum module CS(N) basically correspond to the N inputs of the cumulative sum module CS(N), while the N/2 outputs of the N/2 input adders of the cumulative sum module CS(N) are connected to the N/2 inputs of the cumulative sum module CS(N/2). Similarly, the N/2 inputs of the N/4 input adders of the cumulative sum module CS(N/2) basically correspond to the N/2 inputs of the cumulative sum module CS(N/2), while the N/4 outputs of the N/4 input adders of the cumulative sum module CS(N/2) are connected to the N/4 inputs of the cumulative sum module CS(N/4). And so on.

Therefore, with reference to Figure 6 (exemplary case with N=8), the cumulative sum module CS(8) has 8 inputs and 8 outputs, the cumulative sum module CS(4) has 4 inputs and 4 outputs, and the innermost cumulative sum module CS(2) has 2 inputs and 2 outputs. All the inputs and outputs are represented in Figure 6 as squares. Preferably, the 8 inputs of the 4 input adders Ai80, Ai81, Ai82, Ai83 basically correspond to the 4 inputs of the cumulative sum module CS(8), while the 4 outputs of the 4 input adders Ai80, Ai81, Ai82, Ai83 are connected to the 4 inputs of the cumulative sum module CS(4). Similarly, the 4 inputs of the 2 input adders Ai40, Ai41 basically correspond to the 4 inputs of the cumulative sum module CS(4), while the 2 outputs of the 2 input adders Ai40, Ai41 are connected to the 2 inputs of the cumulative sum module CS(2).

According to this second variant, the even inputs of the cumulative sum module CS(N) preferably bypass all the nested cumulative sum modules. In particular, the first input of the cumulative sum module CS(N) is preferably connected to the first output of the cumulative sum module CS(N), while each of the other (N/2)-1 even inputs of the cumulative sum module CS(N) is connected to an input of a respective one of the (N/2)-1 output adders of the cumulative sum module CS(N). The other input of the (N/2)-1 output adders of the cumulative sum module CS(N) is preferably connected to (N/2)-1 of the N/2 outputs of the cumulative sum module CS(N/2) (except the last one). Similarly, the even inputs of the cumulative sum module CS(N/2) preferably bypass all the nested cumulative sum modules. In particular, the first input of the cumulative sum module CS(N/2) is preferably connected to the first output of the cumulative sum module CS(N/2), while each of the other (N/4)-1 even inputs of the cumulative sum module CS(N/2) is connected to an input of a respective one of the (N/4)-1 output adders of the cumulative sum module CS(N/2). The other input of the (N/4)-1 output adders of the cumulative sum module CS(N/2) is preferably connected to (N/4)-1 of the N/4 outputs of the cumulative sum module CS(N/4) (except the last one). And so on.

Therefore, with reference to Figure 6 (exemplary case with N=8), the even inputs of the cumulative sum module CS(8) preferably bypass the inner cumulative sum modules CS(4) and CS(2). In particular, the first input of the cumulative sum module CS(8) is preferably connected to the first output of the cumulative sum module CS(8), while each of the other 3 even inputs of the cumulative sum module CS(8) is connected to an input of a respective one of the output adders Ao80, Ao81, Ao82. The other input of the output adders Ao80, Ao81, Ao82 is preferably connected to 3 of the 4 outputs of the cumulative sum module CS(4) (except the last one). Similarly, the even inputs of the cumulative sum module CS(4) preferably bypass the inner cumulative sum module CS(2). In particular, the first input of the cumulative sum module CS(4) is preferably connected to the first output of the cumulative sum module CS(4), while the other even input of the cumulative sum module CS(4) is connected to an input of the output adder Ao40. The other input of the output adder Ao40 is preferably connected to one of the 2 outputs of the cumulative sum module CS(2) (not the last one).

When at a clock cycle N=8 samples $X_k$, $X_{k+1}$, ... $X_{k+7}$ are received at the cumulative sum module CS(8), the input adders Ai80, Ai81, Ai82, Ai83 preferably add them two-by-two thereby providing the 4 following sums:

$$Si80=X_k+X_{k+1};$$

$$Si81=X_{k+2}+X_{k+3};$$

$$Si82=X_{k+4}+X_{k+5};$$

and

$$Si83=X_{k+6}+X_{k+7}$$

to the cumulative sum module CS(4). At the same time, the even samples $X_k$, $X_{k+2}$, $X_{k+4}$ and $X_{k+6}$ preferably bypass the cumulative sum modules C(4) and C(2). In particular, the first even sample $X_k$ is directly forwarded at the first output of the cumulative sum module CS(8), while the other even samples $X_{k+2}$, $X_{k+4}$ and $X_{k+6}$ are preferably provided at one of the inputs of the output adders Ao80, Ao81, Ao82, respectively.

Then, in the cumulative sum module CS(4), the input adders Ai40, Ai41 preferably add the sums Si80, Si81, Si82, Si83 two-by-two, thereby providing the 2 following sums:

$$Si40=Si80+Si81=X_k+X_{k+1}+X_{k+2}+X_{k+3};$$

and

$$Si41=Si82+Si83=X_{k+4}+X_{k+5}+X_{k+6}+X_{k+7}$$

to the cumulative sum module CS(2). At the same time, the even sums Si80 and Si82 preferably bypass the cumulative sum module C(2). In particular, the first even sum Si80 is directly forwarded at the first output of the cumulative sum module CS(4), while the other even sum Si82 is preferably provided at one of the inputs of the output adder Ao40.

Then, in the cumulative sum module CS(2), the adder A20 preferably adds the sums Si40 and Si41, thereby providing the followings sum:

$$S20 = Si40 + Si41 = X_k + X_{k+1} + X_{k+2} + X_{k+3} + X_{k+4} + X_{k+5} + X_{k+6} + X_{k+7}.$$

at its output. At the same time, also the sum Si40 is forwarded at the first output of the cumulative sum module CS(2).

Preferably, the first sample $X_k$, the sum Si80, the sum Si40 and the sum S20 are directly forwarded at the output of the cumulative sum module C(8), since they correspond to the cumulative sums $S_k$, $S_{k+1}$, $S_{k+3}$ and $S_{k+7}$, respectively.

Then, in the cumulative sum module CS(4), the output adder Ao40 preferably adds Si40 with Si82, thereby providing the followings sum:

$$So40 = Si40 + Si82 = X_k + X_{k+1} + X_{k+2} + X_{k+3} + X_{k+4} + X_{k+5}.$$

The sum So40 corresponds to the cumulative sum $S_{k+5}$, and is therefore directly forwarded at the output of the cumulative sum module C(8).

Then, in the cumulative sum module CS(8), the output adders Ao80, Ao81 and Ao82 preferably add Si80, Si40 and So40 to the even samples $X_{k+2}$, $X_{k+4}$ and $X_{k+6}$, respectively, thereby providing the followings sums:

$$So80 = Si80 + X_{k+2} = X_k + X_{k+1} + X_{k+2};$$

$$So81 = Si40 + X_{k+4} = X_k + X_{k+1} + X_{k+2} + X_{k+3} + X_{k+4};$$

$$So82 = So40 + X_{k+6} = X_k + X_{k+1} + X_{k+2} + X_{k+3} + X_{k+4} + X_{k+5} + X_{k+6}.$$

The sums So80, So81 and So82 corresponds to the cumulative sums $S_{k+2}$, $S_{k+4}$ and $S_{k+6}$, respectively, and are therefore directly forwarded at the output of the cumulative sum module C(8).

By comparing the cumulative sum module of Figure 5 with the cumulative sum module of Figure 6, it can be noticed that the latter comprises a higher number of adders. Indeed, while the cumulative sum module of Figure 5 comprises N adders, the cumulative sum module of Figure 6 comprises $2N - \log_2(N) - 2$ adders. However, the maximum number of adders operating in cascade is advantageously reduced. Indeed, while in the configuration of Figure 5 all the N adders are cascaded, in the configuration of Figure 6 no more than $2\log_2(N) - 2$ adders are cascaded (the cascade comprising the maximum number of adders is the one providing the cumulative sum $S_{k+6}$ or, more generally, the cumulative sum $S_{k+N-2}$). In other words, the configuration of Figure 6 has a higher parallelism degree than the configuration of Figure 5. As a consequence, a reduced number of delay blocks d is advantageously required for synchronizing inputs and outputs of the various adders. The delay blocks d are not shown in Figure 6 for not overloading the Figure. In particular, if N is the number of samples received at each clock cycle, assuming that each adder performs a sum in a clock cycle and that each delay block d introduces a delay of a single clock cycle, the overall number of delay blocks d preferably is $N \times (2\log_2(N) - 2)$. If 3-4 adders may operate in cascade within a single clock cycle, only two "vertical strips" each comprising N delay blocks d are needed. In this case, only 2N delay blocks d are needed. Therefore, the complexity of the cumulative sum module CS shown in Figure 6 increases substantially proportionally to $N \cdot \log_2(N)$. The configuration of Figure 6 is therefore advantageously much simpler (and therefore much cheaper) than the configuration of Figure 5 since, for a same value of N, it comprises a much lower number of components.

Referring again to Figure 3, while the first register REG1 receives the N integrals $Int_k$, $Int_{k+1}$, ... $Int_{k+N-1}$ from the first addition module S1 and stores them, it preferably forwards the N integrals $Int_{k-N}$, $Int_{k-N+1}$, ...., $Int_{k-1}$ previously stored therein to the second register REG2. The ensemble of the two registers REG1 and REG2 therefore advantageously provides a "window" of 2N integrals.

Then, the first selector MUX1 preferably selects from the first register REG1 and the second register REG2 N integrals, and provides them in parallel at its outputs. In particular, the first selector MUX1 preferably selects from the first register REG1 the last $(N/2) - ((L-1)/2)$ integrals and from the first register REG1 the first $(N/2) + ((L-1)/2)$ integrals. The N integrals selected by the first selector MUX1 are therefore:

$$Int_{k-(N/2)+((L-1)/2)}$$

$$...$$

$$Int_{k+(N/2)-1+((L-1)/2)}.$$

Substantially at the same time, also the second selector MUX2 preferably selects from the first register REG1 and the second register REG2 N integrals, and provides them in parallel at its outputs. In particular, the second selector MUX2 preferably selects from the first register REG1 the last $(N/2)+((L-1)/2)$ integrals and from the first register REG1 the first $(N/2)-((L-1)/2)$ integrals. The N integrals selected by the second selector MUX2 are therefore:

$$Int_{k-(N/2)-((L-1)/2)}$$

$$...$$

$$Int_{k+(N/2)-1-((L-1)/2)}.$$

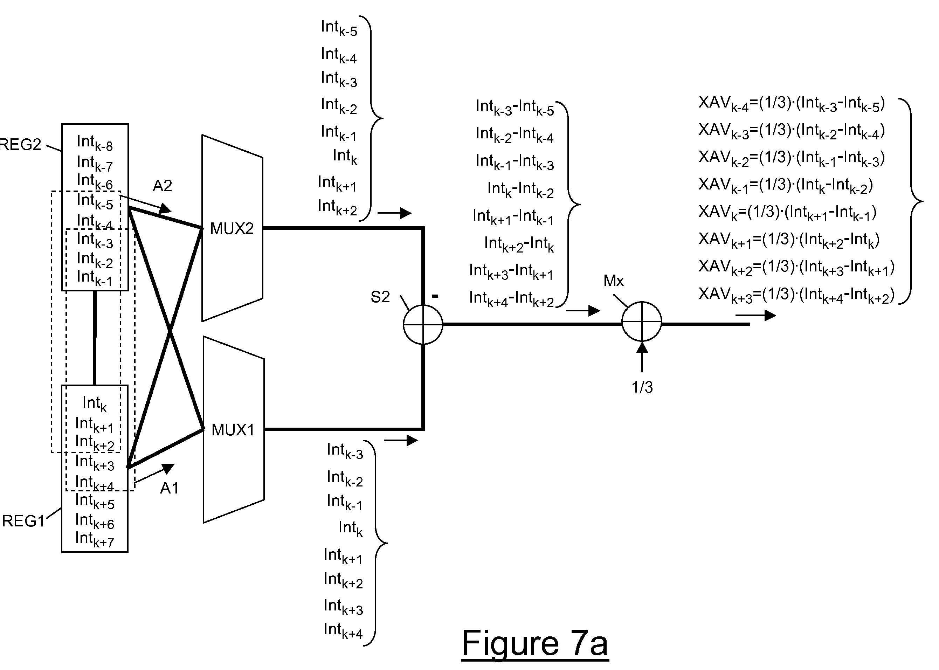

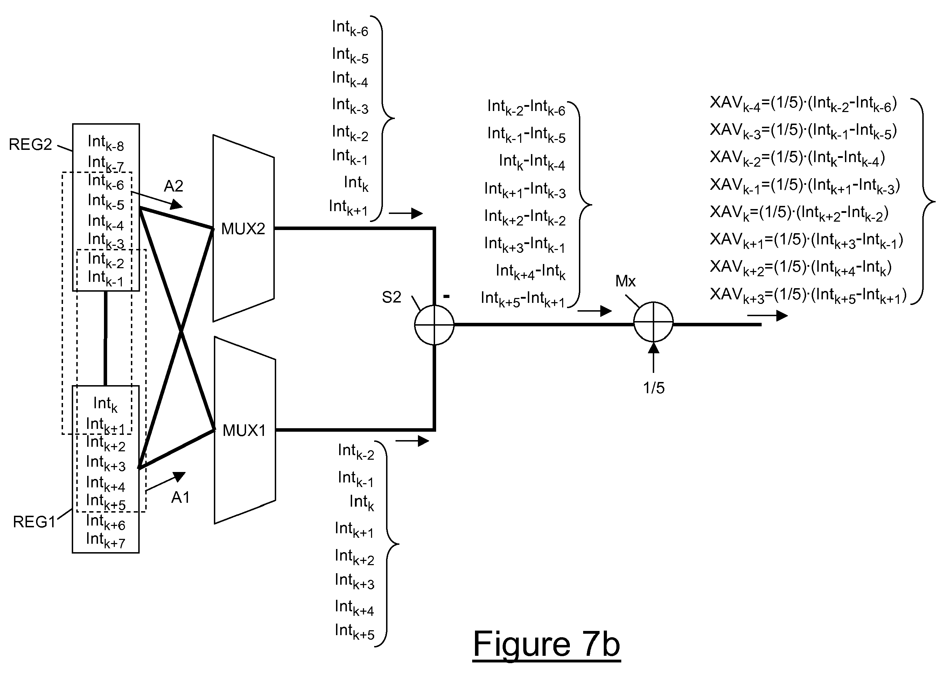

Hence, for allowing proper operation of the first and second selectors MUX1, MUX2, L should be lower than N.
It can be noticed the integrals output by the first selector MUX1 and the second selector MUX2 are offset by L-1. For instance, Figure 7a and 7b schematically show the operation of the registers REG1, REG2 and the selectors MUX1, MUX2 in case L=3 (Figure 7a) and in case L=5 (Figure 7b), in the exemplary situation where N=8. In both cases, the first register REG1 stores N=8 integrals $Int_k$, $Int_{k+1}$, ... $Int_{k+7}$ calculated at a clock cycle, while the second register REG2 stores N=8 integrals $Int_{k-8}$, $Int_{k-7}$, ... $Int_{k-1}$, calculated at the previous clock cycle.
With reference first to Figure 7a (L=3), the first selector MUX1 preferably selects from the first register REG1 and the second register REG2 the N=8 integrals $Int_{k-3}$, $Int_{k-2}$, ..., $Int_{k+4}$ (as indicated by the arrow A1), while the second selector MUX2 preferably selects from the first register REG1 and the second register REG2 the N=8 integrals $Int_{k-5}$, $Int_{k-4}$, ..., $Int_{k+2}$ (as indicated by the arrow A2). The integrals output by the first selector MUX1 and the second selector MUX2 in this first case are offset by L-1=2.
With reference now to Figure 7b (L=5), the first selector MUX1 preferably selects from the first register REG1 and the second register REG2 the N=8 integrals $Int_{k-2}$, $Int_{k-1}$, ..., $Int_{k+5}$ (as indicated by the arrow A1), while the second selector MUX2 preferably selects from the first register REG1 and the second register REG2 the N=8 integrals $Int_{k-6}$, $Int_{k-5}$, ..., $Int_{k+1}$ (as indicated by the arrow A2). The integrals output by the first selector MUX1 and the second selector MUX2 in this first case are offset by L-1=4.
The integrals output by the first selector MUX1 and the integrals output by the second selector MUX2 are then preferably forwarded to the second addition module S2, that preferably calculates N differences according to the above equation [7'], i.e.:

$$Int_{k-(N/2)+((L-1)/2)} - Int_{k-(N/2)-((L-1)/2)}$$

$$...$$

$$Int_{k+(N/2)-1+((L-1)/2)} - Int_{k+(N/2)-1-((L-1)/2)}.$$

It can be noticed that each of the above differences basically is a difference between the integral output by the first selector MUX1 corresponding to the sample which follows the current sample by (L-1)/2 and the integral output by the second selector MUX2 which corresponds to the sample that precedes the current sample by (L-1)/2, in accordance with equation [7'].
Therefore, by referring again to Figure 7a (N=8, L=3), the second addition module S2 preferably calculates N=8 differences as follows:

$$\text{Int}_{k-3}\text{-Int}_{k-5};$$

$$\text{Int}_{k-2}\text{-Int}_{k-4};$$

$$\dots$$

$$\text{Int}_{k+4}\text{-Int}_{k+2}.$$

Similarly, by referring again to Figure 7b (N=8, L=5), the second addition module S2 preferably calculates the N=8 differences as follows:

$$\text{Int}_{k-2}\text{-Int}_{k-6};$$

$$\text{Int}_{k-1}\text{-Int}_{k-5};$$

$$\dots$$

$$\text{Int}_{k+5}\text{-Int}_{k+1}.$$

The N differences are then forwarded to the multiplication module Mx, that preferably multiples each of the N differences by 1/L, thereby providing at its output the following N real averages $XAV_{k-(N/2)}$, ..., $XAV_{k+(N/2)-1}$ according to the above equation [8']:

$$XAV_{k-(N/2)} = \frac{1}{L} \cdot \left( \text{Int}_{k-(N/2)+((L-1)/2)} - \text{Int}_{k-(N/2)-((L-1)/2)} \right)$$

$$\dots$$

$$XAV_{k+(N/2)-1} = \frac{1}{L} \cdot \left( \text{Int}_{k+(N/2)-1+((L-1)/2)} - \text{Int}_{k+(N/2)-1-((L-1)/2)} \right)$$

Therefore, by referring again to Figure 7a (N=8, L=3), the multiplication module Mx preferably calculates N=8 real averages as follows:

$$XAV_{k-4} = (1/3) \cdot (\text{Int}_{k-3}\text{-Int}_{k-5});$$

$$XAV_{k-3} = (1/3) \cdot (\text{Int}_{k-2}\text{-Int}_{k-4});$$

$$\dots$$

$$XAV_{k+3} = (1/3) \cdot (\text{Int}_{k+4}\text{-Int}_{k+2}).$$

Similarly, by referring again to Figure 7b (N=8, L=5), the multiplication module Mx preferably calculates the N=8 real averages as follows:

$$XAV_{k-4} = (1/5) \cdot (\text{Int}_{k-2}\text{-Int}_{k-6});$$

$$XAV_{k-3} = (1/5) \cdot (\text{Int}_{k-1}\text{-Int}_{k-5});$$

$$\dots$$

$$XAV_{k+3} = (1/5) \cdot (\text{Int}_{k+5}\text{-Int}_{k+1}).$$

The N real averages $XAV_{k-(N/2)}$, ..., $XAV_{k+(N/2)-1}$ are then provided at the output of the digital filter Fx. Since, as mentioned above, the operation of the digital filter Fy is basically the same as the operation of the digital filter Fx, in the meanwhile also the second digital filter Fy outputs N imaginary averages $YAV_{k-(N/2)}$, ..., $YAV_{k+(N/2)-1}$. The N real and imaginary averages are then received by the second angle module ANGL2, that processes them as described above.

It can be noticed that the N real averages $XAV_{k-(N/2)}$, ..., $XAV_{k+(N/2)-1}$ output by the filters Fx (and therefore the corresponding imaginary averages output by the filter Fy) are delayed by N/2 relative to the N real samples $X_k$, $X_{k+1}$, ... $X_{k+N-1}$ entering the filter Fx (and therefore the corresponding imaginary samples entering the filter Fy). Therefore, also the N rotation angles $\alpha_k$ calculated by the unwrap module UW based on the N real averages $XAV_{k-(N/2)}$, ..., $XAV_{k+(N/2)-1}$ (and the corresponding imaginary averages) are delayed by N/2 relative to the N angular samples $\theta'_k$ output by the first angle module ANGL1. This delay is advantageously compensated by the delay line D.

Therefore, the ensemble of the two registers REG1, REG2, the two selectors MUX1, MUX2 and the second addition module S2 basically forms a differentiating circuit performing the differentiating operation defined by the above equation [7'].

Advantageously, the length of the filter Fx may be changed by changing L. This operation advantageously does not affect the operation of the integrating circuit, and may be simply implemented by suitably shifting the inputs of the selectors MUX1, MUX2. For instance, with reference to Figures 7a and 7b, increasing the length of the digital filter Fx from L=3 (Figure 7a) to L=5 (Figure 7b) simply requires shifting forward the inputs of the first selector MUX1 by a single position, and shifting backward the inputs of the second selector MUX2 by a single position. Generally speaking, varying the length of the digital filter Fx from a first value L1 to a second value L2 (for instance, when noise conditions change or when one wishes testing the performance of the receiver RX) requires shifting forward the inputs of the first selector MUX1 by (L2-L1)/2 positions, and shifting backward the inputs of the second selector MUX2 by (L2-L1)/2 positions.

Advantageously, this shifting is always symmetric relative to the center of the concatenation of the first and second registers REG1, REG2. Therefore, advantageously, changing the length of the digital filter Fx is hitless (i.e. it does not induce any loss of data), since it does not affect the delay between the N input real samples $X_k$, $X_{k+1}$, ... $X_{k+N-1}$ and the N output real averages $XAV_{k-(N/2)}$, ..., $XAV_{k+(N/2)-1}$. This delay is advantageously constantly equal to N/2, and is therefore compensated by the delay line D independently of the value of L.

In the above description, the digital filter Fx is part of a rotation compensator for an optical coherent receiver. This is however non limiting, since the digital filter Fx may be used in other digital devices suitable for processing digital samples. In particular, the digital filter Fx may be advantageously used each time a moving sum of L consecutive digital samples has to be performed on a sequence of digital samples received at a digital device having a parallelism degree equal to N. The use of the digital filter Fx for calculating a moving average in a rotation compensator for an optical coherent receiver is therefore merely exemplary.

The functions of the various elements shown in Figure 3 may be provided through the use of dedicated hardware, programmable hardware or a hardware capable of executing software in association with appropriate software. In particular, the functions of the various elements shown in Figure 3 are preferably provided through the use of one or more application specific integrated circuits (ASIC) and/or one or more field programmable gate arrays (FPGA). Preferably, the functions of the various elements shown in Figure 3 are provided through the use of a single ASIC or a single FPGA. Therefore, the expressions "integrating circuit" and "differentiating circuit" mentioned in the claims are to be understood merely as functional aggregations of the elements of the digital filter, and they should not be understood necessarily as physically separated circuits implemented on separated hardware devices.

**Claims**

1. A digital filter (Fx) configured to receive a sequence of digital samples, said digital filter (Fx) being configured to receive in parallel N digital samples ($X_k$) of said sequence at each clock cycle of a clock signal suitable for synchronizing operation of said digital filter (Fx), N being an integer higher than 1, and to calculate a sum ($XAV_k$) of L consecutive digital samples of said sequence, L being an odd integer equal to or higher than 3 and lower than N, said digital filter (Fx) comprising:

   - an integrating circuit (CS, S1, REG1, D) configured to calculate a first integral ($Int_{k-((L-1)/2)}$) of said sequence up to a first digital sample ($X_{k-((L-1)/2)}$) of said L consecutive digital samples and a last integral ($Int_{k+((L-1)/2)}$) of said sequence up to a last digital sample ($X_{k+((L-1)/2)}$) of said L consecutive digital samples; and
   - a differentiating circuit (REG1, REG2, MUX1, MUX2, S2) configured to calculate said sum ($XAV_k$) as a difference between said last integral ($Int_{k+((L-1)/2)}$) and said first integral ($Int_{k-((L-1)/2)}$),

   wherein said integrating circuit (CS, S1, REG1, D) comprises a cumulative sum module (CS), an addition module (S1) connected to said cumulative sum module (CS) and a first register (REG1) retroactively connected to said addition module (S1), wherein:

- said cumulative sum module (CS) is configured to calculate a last cumulative sum ($S_{k+((L-1)/2)}$) of said last digital sample ($X_{k+((L-1)/2)}$) and preceding digital samples of said sequence received within a same clock cycle as said last digital sample ($X_{k+((L-1)/2)}$);
- said first register (REG1) is configured to store a delayed integral ($Int_{k-1}$) calculated on digital samples of said sequence received before said same clock cycle; and
- said addition module (S1) is configured to calculate said last integral ($Int_{k+((L-1)/2)}$) by adding said last cumulative sum ($S_{k+((L-1)/2)}$) and said delayed integral ($Int_{k-1}$).

2. The digital filter (Fx) according to claim 1, wherein said cumulative sum module (CS) is configured to receive in parallel N digital samples ($X_k$, $X_{k+1}$, ... $X_{k+N-1}$) of said sequence of digital samples in said same clock cycle, and to provide N cumulative sums ($S_k$, $S_{k+1}$, ... $S_{k+N-1}$) in parallel, said N cumulative sums ($S_k$, $S_{k+1}$, ... $S_{k+N-1}$) including said last cumulative sum ($S_{k+((L-1)/2)}$).

3. The digital filter (Fx) according to claim 2, wherein said addition module (S1) is configured to receive in parallel said N cumulative sums ($S_k$, $S_{k+1}$, ... $S_{k+N-1}$) and to add said delayed integral ($Int_{k-1}$) to each of said N cumulative sums ($S_k$, $S_{k+1}$, ... $S_{k+N-1}$), thereby providing in parallel N currently calculated integrals ($Int_k$, $Int_{k+1}$, ... $Int_{k+,N-1}$), said N currently calculated integrals ($Int_k$, $Int_{k+1}$, ... $Int_{k+N-1}$) including said last integral ($Int_{k+((L-1)/2)}$).

4. The digital filter (Fx) according to claim 3, wherein said first register (REG1) is configured to:

- before receiving said N currently calculated integrals ($Int_k$, $Int_{k+1}$, ... $Int_{k+N-1}$), storing N previously calculated integrals ($Int_{k-N}$, $Int_{k-N+1}$, ... $Int_{k-1}$), said N previously calculated integrals ($Int_{k-N}$, $Int_{k-N+1}$, ... $Int_{k-1}$) including said delayed integral ($Int_{k-1}$) and said first integral ($Int_{k-((L-1)/2)}$); and
- receive from said addition module (S1) said N currently calculated integrals ($Int_k$, $Int_{k+1}$, ... $Int_{k+N-1}$) and store them, thereby overwriting said N previously calculated integrals ($Int_{k-N}$, $Int_{k-N+1}$, ... $Int_{k-1}$).

5. The digital filter (Fx) according to claim 4, wherein said differentiating circuit (REG1, REG2, MUX1, MUX2, S2) comprises a second register (REG2) cooperating with said first register (REG1), and wherein said first register (REG1) is configured to, upon reception of said N currently calculated integrals ($Int_k$, $Int_{k+1}$, ... $Int_{k+N-1}$), forward said N previously calculated integrals ($Int_{k-N}$, $Int_{k^-N+1}$, ... $Int_{k-1}$) to said second register (REG2), before overwriting them.

6. The digital filter (Fx) according to claim 5, wherein said differentiating circuit (REG1, REG2, MUX1, MUX2, S2) further comprises a first selector (MUX1) and a second selector (MUX2) connected to said first register (REG1) and said second register (REG2), and wherein:

- said first selector (MUX1) is configured to read from said first register (REG1) and said second register (REG2) N minuend integrals ($Int_{k-(N/2)+((L-1)/2)}$, ... $Int_{k+(N/2)-1+((L-1)/2)}$) selected among said N previously calculated integrals ($Int_{k-N}$, $Int_{k-N+1}$, ... $Int_{k-1}$) and said N currently calculated integrals ($Int_k$, $Int_{k+1}$, ... $Int_{k+N-1}$), said N minuend integrals ($Int_{k-(N/2)+((L-1)/2)}$, ... $Int_{k+(N/2)-1+((L-1)/2)}$) including said last integral ($Int_{k+((L-1)/2)}$); and
- said second selector (MUX2) is configured to read from said first register (REG1) and said second register (REG2) N subtrahend integrals ($Int_{k-(N/2)-((L-1)/2)}$, ... $Int_{k+(N/2)-1-((L-1)/2)}$) selected among said N previously calculated integrals ($Int_{k-N}$, $Int_{k-N+1}$, ... $Int_{k-1}$) and said N currently calculated integrals ($Int_k$, $Int_{k+1}$, ... $Int_{k+N-1}$), said N subtrahend integrals ($Int_{k-(N/2)-((L-1)/2)}$, ... $Int_{k+(N/2)-1-((L-1)/2)}$) including said first integral ($Int_{k-((L-1)/2)}$), wherein said N minuend integrals ($Int_{k-(N/2)+((L-1)/2)}$, ... $Int_{k+(N/2)-1+((L-1)/2)}$) are shifted by L-1 relative to said N subtrahend integrals ($Int_{k-(N/2)-((L-1)/2)}$, ... $Int_{k+(N/2)-1-((L-1)/2)}$).

7. The digital filter (Fx) according to claim 6, wherein:

- said N minuend integrals ($Int_{k-(N/2)+((L-1)/2)}$, ... $Int_{k+(N/2)-1+((L-1)/2)}$) are a concatenation of the last (N/2)-((L-1)/2) integrals of said N previously calculated integrals ($Int_{k-N}$, $Int_{k-N+1}$, ... $Int_{k-1}$) and the first (N/2)+((L-1)/2) integrals of said N currently calculated integrals ($Int_k$, $Int_{k+1}$, ... $Int_{k+N-1}$); and
- said N subtrahend integrals ($Int_{k-(N/2)-((L-1)/2)}$, ... $Int_{k+(N/2)-1-((L-1)/2)}$) are a concatenation of the last (N/2)+((L-1)/2) integrals of said N previously calculated integrals ($Int_{k-N}$, $Int_{k-N+1}$, ... $Int_{k-1}$) and the first (N/2)-((L-1)/2) integrals of said N currently calculated integrals ($Int_k$, $Int_{k+1}$, ... $Int_{k+N-1}$).

8. The digital filter (Fx) according to claim 6 or 7, wherein said differentiating circuit (REG1, REG2, MUX1, MUX2, S2) further comprises a second addition module (S2) connected to said first selector (MUX1) and said second selector (MUX2), said second addition module (S2) being configured to calculate N differences between said N minuend integrals $(Int_{k-(N/2)+((L-1)/2)}, \ldots Int_{k+(N/2)-1+((L-1)/2)})$ and said N subtrahend integrals $(Int_{k-(N/2)-((L-1)/2)}, \ldots Int_{k+(N/2)-1-((L-1)/2)})$, said N differences including said difference between said last integral $(Int_{k+((L-1)/2)})$ and said first integral $(Int_{k-((L-1)/2)})$.

9. The digital filter (Fx) according to any of the preceding claims, wherein said cumulative sum module (CS(8)) comprises $\log_2(N)-1$ further cumulative sum modules (SC(4), CS(2)) nested one in the other.

10. The digital filter (Fx) according to claim 9, wherein:

- said cumulative sum module (CS(8)) comprises N/2 input adders (Ai80, Ai81, Ai82, Ai83), (N/2)-1 output adders (Ao80, Ao81, Ao82) and a first further cumulative sum module (CS(4)) interposed between said N/2 input adders (Ai80, Ai81, Ai82, Ai83) and said (N/2)-1 output adders (Ao80, Ao81, Ao82); and
- said first further cumulative sum module (CS(4)) comprises N/4 first further input adders (Ai40, Ai41), (N/4)-1 first further output adders (Ao40) and a second further cumulative sum module (CS(2)) interposed between said N/4 first further input adders (Ai40, Ai41) and said (N/4)-1 first further output adders (Ao40).

11. The digital filter (Fx) according to claim 9 or 10, wherein said further cumulative sum modules (SC(4), CS(2)) include an innermost further cumulative sum module (CS(2)) in turn comprising a single adder.

12. The digital filter (Fx) according to any of claims 1 to 8, wherein said cumulative sum module (CS) comprises N cascaded adders.

13. A rotation compensator (RC) for an optical coherent receiver (RX) configured to receive a modulated optical signal (s(t)), process said modulated optical signal (s(t)) for generating an in-phase component (I') and a quadrature component (Q'), and sample said in-phase component (I') and said quadrature component (Q') for generating couples of samples $(I'_k, Q'_k)$ of said in-phase component (I') and said quadrature component (Q'), said couples of samples $(I'_k, Q'_k)$ forming a received constellation that is rotated relative to a reference constellation by a rotation angle, said rotation compensator (RC) comprising:

- a first angle module (ANGL1) configured to receive in parallel N couples of samples $(I'_k, Q'_k)$ and to convert them in N corresponding angular samples $(\theta'_k)$;
- an estimating circuit (M1, SC1, Fx, Fy, ANGL2, M2, UW) configured to process said N corresponding angular samples $(\theta'_k)$ for estimating N rotation angles $(\alpha_k)$;
- a compensating circuit (D, S) configured to apply said N rotation angles $(\alpha_k)$ to said N corresponding angular samples $(\theta'_k)$, thereby providing N compensated angular samples $(\theta''_k)$; and
- a first sine-cosine module (SC2) configured to receive said N compensated angular samples $(\theta''_k)$ in parallel and to convert them in N corresponding couples of compensated samples $(I''_k, Q''_k)$,

wherein said estimating circuit (M1, SC1, Fx, Fy, ANGL2, M2, UW) comprises a digital filter (Fx, Fy) according to any of the preceding claims.

14. A coherent optical receiver (RX) for an optical communication network configured to receive a modulated optical signal (s(t)) and to process said modulated optical signal (s(t)) for generating an in-phase component (I') and a quadrature component (Q'), said coherent optical receiver (RX) comprising a rotation compensator (RC) according to claim 13.

15. An optical communication network comprising an optical coherent receiver (RX) according to claim 14.

**Patentansprüche**

1. Ein Digitalfilter (Fx), konfiguriert für den Empfang einer Sequenz digitaler Muster, wobei besagter Digitalfilter (Fx) dafür konfiguriert ist, um parallel N digitale Muster $(X_k)$ besagter Sequenz in jedem Taktzyklus eines Taktsignals zu empfangen, welches geeignet ist für das Synchronisieren des Betriebs besagten Digitalfilters (Fx), wobei N eine ganze Zahl größer 1 ist, sowie weiterhin für das Berechnen einer Summe $(XAV_k)$ von L aufeinanderfolgenden, digitalen Mustern besagter Sequenz, wobei L eine ungerade ganze Zahl gleich oder größer als 3 und kleiner als N ist, wobei besagter Digitalfilter (Fx) umfasst:

- eine Integrierschaltung (CS, S1, REG1, D), die konfiguriert ist für das Berechnen eines ersten Integrals ($Int_{k-((L-1)/2)}$) besagter Sequenz bis zu einem ersten digitalen Muster ($X_{k-((L-1)/2)}$) der besagten, L aufeinanderfolgenden digitalen Muster und eines letzten Integrals ($In_{k+((L-1)/2)}$) besagter Sequenz bis zum letzten digitalen Muster ($X_{k+((L-1)/2)}$) der besagten L aufeinanderfolgenden digitalen Muster; und

- eine Differenzierschaltung (REG1, REG2, MUX1, MUX2, S2), die konfiguriert ist für das Berechnen der Summe ($XAV_k$) als Differenz zwischen besagtem letztem Integral ($Int_{k+((L-1)/2)}$) und besagtem erstem Integral ($Int_{k-((L-1)/2)}$),

wobei besagte Integrierschaltung (CS, S1, REG1, D) ein kumulatives Summiermodul (Cumulative Sum, CS), ein mit besagtem kumulativem Summiermodul (CS) verbundenes Additionsmodul (S1) und ein erstes Register (REG1) umfasst, das retroaktiv mit besagtem Additionsmodul (S1) verbunden ist, wobei:

- besagtes kumulatives Summiermodul (CS) konfiguriert ist für das Berechnen einer letzten kumulativen Summe ($S_{k+((L-1)/2)}$) besagten letzten digitalen Musters ($X_{k+((L-1)/2)}$) und vorangehender digitaler Muster aus besagter Sequenz, die innerhalb eines selben Taktzyklus wie besagtes letztes digitales Muster ($X_{k+((L-1)/2)}$) empfangen wurden;

- besagtes erstes Register (REG1) konfiguriert ist für das Speichern eines verzögerten Integrals ($Int_{k-1}$), berechnet auf der Grundlage solcher digitaler Muster besagter Sequenz, die vor besagtem selbem Taktzyklus empfangen wurden; und

- besagtes Additionsmodul (S1) konfiguriert ist für das Berechnen besagten letzten Integrals ($Int_{k+((L-1)/2)}$) durch das Addieren besagter letzter kumulativer Summe ($S_{k+((L-1)/2)}$) und besagten verzögerten Integrals ($Int_{k-1}$).

2. Der Digitalfilter (Fx) nach Anspruch 1, wobei besagtes kumulatives Summiermodul (CS) konfiguriert ist für den parallelen Empfang von N digitalen Mustern ($X_k$, $X_{k-1}$ ... $X_{k+N-1}$) besagter Sequenz digitaler Muster in besagtem selbem Taktzyklus und für das parallele Bereitstellen von N kumulativen Summen ($S_k$, $S_{k+1}$ ... $S_{k+N-1}$), wobei besagte N kumulative Summen ($S_k$, $S_{k+1}$... $S_{k+N-1}$) besagte letzte kumulative Summe ($S_{k+((L-1)/2)}$) umfassen.

3. Der Digitalfilter (Fx) nach Anspruch 2, wobei besagtes Additionsmodul (S1) konfiguriert ist für den parallelen Empfang besagter N kumulativer Summen ($S_k$, $S_{k+1}$ ... $S_{k+N-1}$) und für das Hinzufügen besagten verzögerten Integrals ($Int_{k-1}$) zu jeder der besagten, N kumulativen Summen ($S_k$, $S_{k+1}$ ... $S_{k+N-1}$), dadurch parallel N aktuell berechnete Integrale ($Int_k$, $Int_{k+1}$ ... $Int_{k+N-1}$) zur Verfügung stellend, wobei die besagten, N aktuell berechneten Integrale ($Int_k$, $Int_{k+1}$ ... $Int_{k+N-1}$) besagtes letztes Integral ($Int_{k+((L-1)/2)}$) umfassen.

4. Der Digitalfilter (Fx) nach Anspruch 3, wobei besagtes erstes Register (REG1) konfiguriert ist für:

- das vor dem Empfang besagter, N aktuell berechneter Integrale ($Int_k$, $Int_{k+1}$ ... $Int_{k+N-1}$) erfolgende Speichern N zuvor berechneter Integrale ($Int_{k-N}$, $Int_{k-N+1}$, ... $Int_{k-1}$), wobei besagte N zuvor berechneten Integrale ($Int_{k-N}$, $Int_{k-N+1}$, ... $Int_{k-1}$) besagtes verzögertes Integral ($Int_{k-1}$) und besagtes erstes Integral ($Int_{k+((L-1)/2)}$) umfassen; und

- den Empfang von besagtem Additionsmodul (S1) der besagten, N aktuell berechneten Integrale ($Int_k$, $In_{k+1}$ ... $Int_{k+N-1}$) und deren Speichern, dadurch besagte, N zuvor berechnete Integrale ($Int_{k-N}$, $Int_{k-N+1}$, ... $Int_{k-1}$) überschreibend.

5. Der Digitalfilter (Fx) nach Anspruch 4, wobei besagte Differenzierschaltung (REG1, REG2, MUX1, MUX2, S2) ein zweites Register (REG2) umfasst, das mit besagtem erstem Register (REG1) kooperiert, und wobei besagtes erstes Register (REG1) dafür konfiguriert ist, um auf den Empfang besagter N aktuell berechneter Integrale ($Int_k$, $Int_{k+1}$ ... $Int_{k+N-1}$) hin besagte N zuvor berechneten Integrale ($Int_{k-N}$, $Int_{k-N+1}$ .., $Int_{k-1}$) an besagtes zweites Register (REG2), weiterzuleiten, ehe sie überschrieben werden.

6. Der Digitalfilter (Fx) nach Anspruch 5, wobei besagte Differenzierschaltung (REG1, REG2, MUX1, MUX2, S2) weiterhin einen ersten Selektor (MUX1) und einen zweiten Selektor (MUX2) umfasst, die mit besagtem erstem Register (REG1) und besagtem zweitem Register (REG2) verbunden sind, und wobei:

- besagter erster Selektor (MUX1) dafür konfiguriert ist, um aus besagtem erstem Register (REG1) und besagtem zweitem Register (REG2) N Minuend-Integrale ($Int_{k-(N/2)+((L-1)/2)}$, ... $Int_{k+(N/2)-1+((L-1)/2)}$) auszulesen, die aus besagten N zuvor berechneten Integralen ($Int_{k-N}$, $Int_{k-N+1}$, ... $Int_{k-1}$) und besagen N aktuell berechneten Integralen ($Int_k$, $Int_{k+1}$, ... $Irlt_{k-N-1}$) ausgewählt wurden, wobei besagte Minuend-Integrale ($Int_{k-(N/2)}$, $_{+((L-1)/2)}$, ... $Int_{k+(N/2)-1+((L-1)/2)}$) besagtes letztes Integral ($Int_{k+((L-1)/2)}$) umfassen; und

- besagter zweiter Selektor (MUX2) dafür konfiguriert ist, um aus besagtem erstem Register (REG1) und besagtem zweitem Register (REG2) N Substrahend-Integrale ($Int_{k-(N/2)-((L-1)/2)}$, ... $Int_{k+(N/2)-1-((L-1)/2)}$) auszulesen, die aus besagten N zuvor berechneten Integralen ($Int_{k-N}$, $Int_{k-N+1}$, ... $Int_{k-1}$) und besagten N aktuell berechneten Integralen ($Int_k$, $Int_{k+1}$ ... $Int_{k+N-1}$) ausgewählt wurden, wobei besagte Substrahend-Integrale ($Int_{k-(N/2)-((L-1)/2)}$, ... $Int_{k+(N/2)-1((L-1)/2)}$) besagtes erstes Integral ($Int_{-((L-1)/2)}$) umfassen, wobei besagte N Minuend-Integale ($Int_{k-(N/2)+((L-1)/2)}$, .... $Int_{k+(N/2)-1+((L-1)/2)}$,) um L-1 in besagte Substrahend-Integrale ($Int_{k-(N/2)-((L-1)/2)}$, ... $Int_{k+(N/2)-1-(L-1)/2)}$) umgewandelt werden.

7. Der Digitalfilter (Fx) nach Anspruch 6, wobei:

   - besagte N Minuend-Integale ($Int_{k-(N/2)+((L-1)/2)}$, ... $Int_{k+(N/2)-1+((L-1)/2)}$,) eine Verknüpfung der letzten (N/2)-((L-1)/2) Integrale besagter N zuvor berechneten Integrale ($Int_{k-N}$, $Int_{k-N+1}$, ... $Int_{k-1}$) und der ersten (N/2)+((L-1)/2) Integrale besagter N aktuell berechneten Integrale ($Int_k$, $Int_{k+1}$ ... $In_{k+N-1}$) sind; und
   - besagte N Substrahend-Integale ($Int_{k-(N/2)-((L-1)/2)}$, ... $Int_{k+(N/2)-1-((L-1)/2)}$) eine Verknüpfung der letzten (N/2)+((L-1)/2) Integrale besagter N zuvor berechneten Integrale ($Int_{k-N}$, $Int_{k-N+1}$, ... $Int_{k-1}$) und der ersten (N/2)-((L-1)/2) Integrale besagter N aktuell berechneten Integrale ($Int_k$, $Int_{k+1}$ ... $Int_{k+N-1}$).

8. Der Digitalfilter (Fx) nach Anspruch 6 oder 7, wobei besagte Differenzierschaltung (REG1, REG2, MUX1, MUX2, S2) weiterhin ein zweites Additionsmodul (S2) umfasst, das mit besagtem erstem Selektor (MUX1) und besagtem zweitem Selektor (MUX2) verbunden ist, wobei besagtes zweites Additionsmodul (S2) konfiguriert ist für das Berechnen von N Differenzen zwischen besagten N Minuend-Integalen ($Int_{k-(N/2)+((L-1)/2)}$, ... $Int_{k+(N/2)-1-((L-1)/2)}$,) und besagten N Substrahend-Integralen ($Int_{k-(N/2)-((L-1)/2)}$, ... $Int_{k+(N/2)-1-((L-1)/2)}$), wobei besagte N Differenzen besagte Differenz zwischen besagtem letztem Integral ($Int_{k+((L-1)/2)}$) und besagtem erstem Integral ($Int_{k-((L-1)/2)}$) umfassen.

9. Der Digitalfilter (Fx) nach einem jeglichen der vorgenannten Ansprüche, wobei besagtes Modul kumulativer Summen (CS(8)) $\log_2(N)-1$ weitere Module kumulativer Summen (SC(4), CS(2)) umfasst, die ineinander verschachtelt sind.

10. Der Digitalfilter (Fx) nach Anspruch 9, wobei:

    - besagtes Modul kumulativer Summen (CS(8)) N/2 Inputaddierer (Ai80, Ai81, Ai82, Ai83), (N/2)-1 Outputaddierer (Ao80, Apo81, Ao82) und ein erstes weiteres Modul für kumulative Summen (CS(4)) umfasst, das zwischen besagte N/2 Inputaddierer (Ai80, Ai81, Ai82, Ai83) und besagte (N/2)-1 Outputaddierer (Ao80, Ao81, Ao82) zwischengeschaltet ist; und
    - wobei besagtes erstes weitere Modul für kumulative Summen (CS(4)) N/4 erste weitere Inputaddierer (Ai40, Ai41), (N/4)-1 erste weitere Outputaddierer (Ao40) und ein zweites weiteres Modul für kumulative Summen (CS(2)) umfasst, das zwischen besagte N/4 erste weitere Inputaddierer (Ai40, Ai41) und besagte (N/4)-1 erste weitere Outputaddierer (Ao40) zwischengeschaltet ist.

11. Der Digitalfilter (Fx) nach Anspruch 9 oder 10, wobei besagte weitere Modelle für kumulativen Summen (SC(4), CS(2)) ein weiteres, innerstes Modul für kumulative Summen (CS(2)) umfasst, das wiederum einen einzelnen Addierer umfasst.

12. Der Digitalfilter (Fx) nach einem jeglichen der Ansprüche 1 bis 8, wobei besagtes Modul für kumulative Summen (CS) N kaskadierte Addierer umfasst.

13. Rotationskompensator (Rotation Compensator, RC) für einen kohärenten optischen Empfänger (RX), der konfiguriert ist für den Empfang eines modulierten optischen Signals (s(t)), das Verarbeiten besagten modulierten optischen Signals (s(t)) zwecks Generierens einer In-Phase-Komponente (I') und einer Quadraturkomponente (Q') sowie für das Sampeln besagter In-Phase-Komponente (I') und besagter Quadraturkomponente (Q') zwecks Generierens von Musterpaaren ($I'_k$, $Q'_k$) besagter In-Phase-Komponente (I') und besagter Quadraturkomponente (Q'), wobei besagte Musterpaare ($I'_k$, $Q'_k$) eine empfangene Konstellation bilden, die im Verhältnis zu einer Referenzkonstellation um einen Rotationswinkel gedreht wird, wobei besagter Rotationskompensator (RC) umfasst:

    - ein erstes Winkelmodul (ANGL1), das konfiguriert ist für den parallelen Empfang von N Musterpaaren ($I'_k$, $Q'_k$) und für deren Konvertieren in N entsprechende Winkelmuster ($\theta'_k$);
    - eine Schätzschaltung (M1, SC1, Fx, Fy, ANGL2, M2, UW), die konfiguriert ist für das Verarbeiten der besagten, entsprechenden N Winkelmuster ($\theta'_k$) zum Schätzen von N Rotationswinkeln ($\alpha_k$);
    - Kompensationsschaltung (D,S), die konfiguriert ist für die Anwendung besagter N Rotationswinkel ($\alpha_k$) auf

die besagten, entsprechenden N Winkelmuster ($\theta''_k$), dadurch N kompensierte Winkelmuster ($\theta''_k$) zur Verfügung stellend; und

- ein erstes Sinus/Cosinus-Modul (SC2), konfiguriert für den parallelen Empfang der besagten, N kompensierten Winkelmuster ($\theta''_k$) und für deren Konvertieren in N entsprechende, kompensierte Musterpaare ($I''_k$, $Q''_k$),

wobei besage Schätzschaltung (M1, SC1, Fx, Fy, ANGL2, M2, UW) einen digitalen Filter (Fx, Fy) nach einem jeglichen der vorgenannten Ansprüche umfasst,.

**14.** Kohärenter optischer Empfänger (RX) für ein optisches Kommunikationsnetzwerk, dafür konfiguriert, ein moduliertes optisches Signal (s(t)) zu empfangen und das besagte, modulierte optische Signal (s(t)) zu verarbeiten, um eine In-Phase-Komponente (I') und eine Quadratur-Komponente (Q') zu erzeugen, wobei der besagte, kohärente optische Empfänger (RX) einen Rotationskompensator (RC) nach Anspruch 13 umfasst.

**15.** Optisches Kommunikationsnetzwerk, einen kohärenten optischen Empfänger (RX) nach Anspruch 14 umfassend.

## Revendications

**1.** Filtre numérique (Fx) configuré pour recevoir une séquence d'échantillons numériques, ledit filtre numérique (Fx) étant configuré pour recevoir en parallèle N échantillons numériques ($X_k$) de ladite séquence à chaque cycle d'horloge d'un signal d'horloge adapté à l'opération de synchronisation dudit filtre numérique (Fx), N étant un nombre entier supérieur à 1, et pour calculer une somme ($XAV_k$) de L échantillons numériques consécutifs de ladite séquence, L étant un nombre entier impair égal ou supérieur à 3 et inférieur à N, ledit filtre numérique (Fx) comprenant :

- un circuit d'intégration (CS, S1, REG1, D) configuré pour calculer une première intégrale ($Int_{k-((L-1)/2)}$) de ladite séquence jusqu'à un premier échantillon numérique ($X_{k-((L-1)/2)}$) desdits L échantillons numériques consécutifs et une dernière intégrale ($Int_{k+((L-1)/2)}$) de ladite séquence jusqu'à un dernier échantillon numérique ($X_{k+((L-1)/2)}$) desdits L échantillons numériques consécutifs ; et
- un circuit de différentiation (REG1, REG2, MUX1, MUX2, S2) configuré pour calculer ladite somme ($XAV_k$) comme une différence entre ladite dernière intégrale ($Int_{k+((L-1)/2)}$) et ladite première intégrale ($Int_{k-((L-1)/2)}$),

dans lequel ledit circuit d'intégration (CS, S1, REG1, D) comprend un module de somme cumulée (CS), un module d'addition (S1) connecté audit module de somme cumulée (CS) et un premier registre (REG1) connecté rétroactivement audit module d'addition (S1), dans lequel :

- ledit module de somme cumulée (CS) est configuré pour calculer une dernière somme cumulée ($S_{k+((L-1)/2)}$) dudit dernier échantillon numérique ($X_{k+((L-1)/2)}$) et des échantillons numériques précédents de ladite séquence reçue dans le même cycle d'horloge que ledit échantillon numérique ($X_{k+((L-1)/2)}$) ;
- ledit premier registre (REG1) est configuré pour stocker une intégrale retardée ($Int_{k-1}$) calculée sur des échantillons numériques de ladite séquence reçue avant ledit même cycle d'horloge ; et
- ledit module d'addition (S1) est configuré pour calculer ladite dernière intégrale ($Int_{k+((L-1)/2)}$) en ajoutant ladite dernière somme cumulée ($S_{k+((L-1)/2)}$) et ladite intégrale retardée ($Int_{k-1}$).

**2.** Filtre numérique (Fx) selon la revendication 1, dans lequel ledit module de somme cumulée (CS) est configuré pour recevoir en parallèle N échantillons numériques ($X_k$, $X_{k+1}$, ...$X_{k+N-1}$) de ladite séquence d'échantillons numériques dans ledit même cycle d'horloge, et pour fournir N sommes cumulées ($S_k$, $S_{k+1}$, ...$S_{k+N-1}$) en parallèle, lesdites N sommes cumulées ($S_k$, $S_{k+1}$, ... $S_{k+N-1}$) comprenant ladite dernière somme cumulée ($S_{k+((L-1)/2)}$).

**3.** Filtre numérique (Fx) selon la revendication 2, dans lequel ledit module d'addition (S1) est configuré pour recevoir en parallèle lesdites N sommes cumulées ($S_k$, $S_{k+1}$,...$S_{k+N}$-$_1$) et pour ajouter ladite intégrale retardée ($Int_{k-1}$) à chacune desdites N sommes cumulées ($S_k$, $S_{k+1,...}S_{k+N-1}$), fournissant ainsi en parallèle N intégrales calculées actuellement ($Int_k$, $Int_{k+1}$,... $Int_{k+N-1}$), lesdites N intégrales calculées actuellement ($Int_k$, $Int_{k+1}$, ... $Int_{k+N-1}$) comprenant ladite dernière intégrale ($Int_{k+((L-1)/2)}$)

**4.** Filtre numérique (Fx) selon la revendication 3, dans lequel ledit premier registre (REG1) est configuré pour :

- avant de recevoir lesdites N intégrales calculées actuellement ($Int_k$, $Int_{k+1}$, ... $Int_{k+N-1}$), stocker N intégrales précédemment calculées ($Int_{k-N}$, $Int_{k-N+1}$, ... $Int_{k-1}$), lesdites N intégrales précédemment calculées ($Int_{k-N}$,

$Int_{k-N+1}$, ... $Int_{k-1}$), comprenant ladite intégrale retardée ($Int_{k-1}$) et ladite première intégrale ($Int_{k-((L-1)/2)}$) ; et
- recevoir à partir dudit module d'addition (S1) lesdites N intégrales calculées actuellement ($Int_k$, $Int_{k+1}$, ... $Int_{k+N-1}$) et les stocker, écrasant ainsi lesdites N intégrales précédemment calculées ($Int_{k-N}$, $Int_{k-N+1}$, ... $Int_{k-1}$).

5. Filtre numérique (Fx) selon la revendication 4, dans lequel ledit circuit de différentiation (REG1, REG2, MUX1, MUX2, S2) comprend un deuxième registre (REG2) coopérant avec ledit premier registre (REG1), et dans lequel ledit premier registre (REG1) est configuré, dès réception desdites N intégrales calculées actuellement ($Int_k$, $Int_{k+1}$, ... $Int_{k+N-1}$), pour transférer lesdites N intégrales précédemment calculées ($Int_{k-N}$, $Int_{k-N+1}$, ... $Int_{k-1}$), vers ledit deuxième registre (REG2), avant de les écraser.

6. Filtre numérique (Fx) selon la revendication 5, dans lequel ledit circuit de différentiation (REG1, REG2, MUX1, MUX2, S2) comprend en outre un premier sélecteur (MUX1) et un deuxième sélecteur (MUX2) connectés audit premier registre (REG1) et audit deuxième registre (REG2), et dans lequel :

   - ledit premier sélecteur (MUX1) est configuré pour lire à partir dudit premier registre (REG1) et dudit deuxième registre (REG2) N intégrales du diminuende ($Int_{k+((L-1)/2)}$,...$Int_{k+(N/2)-1+((L-1)/2)}$) sélectionnées parmi lesdites N intégrales calculées précédemment ($Int_{k-N}$, $Int_{k-N+1}$, ... $Int_{k-1}$) et lesdites N intégrales calculées actuellement ($Int_k$, $Int_{k+1}$, ... $Int_{k+N-1}$), lesdites N intégrales du diminuende ($Int_{k-(N/2)+((L-1)/2)}$,...$Int_{k+(N/2)-1+((L-1)/2)}$) comprenant ladite dernière intégrale ($Int_{k+((L1)/2)}$) ; et
   - ledit deuxième sélecteur (MUX2) est configuré pour lire à partir dudit premier registre (REG1) et dudit deuxième registre (REG2) N intégrales du diminuteur ($Int_{k-(N/2)-((L-1)/2)}$,..$Int_{k+(N/2)-1-((L-1)/2)}$) sélectionnées parmi lesdites N intégrales calculées précédemment ($Int_{k-N}$, $Int_{k-N+1}$, $Int_{k-1}$) et lesdites N intégrales calculées actuellement ($Int_k$, $Int_{k+1}$,...$Int_{k+N-1}$), lesdites N intégrales du diminuteur ($Int_{k-(N/2)-((L-1)/2)}$,...$Int_{k+(N/2)-1-((L-1)/2)}$) comprenant ladite première intégrale ($Int_{k-((L-1)/2)}$), dans lequel lesdites N intégrales du diminuende ($Int_{k-(N/2)+((L-1)/2)}$,...$Int_{k+(N/2)-1+((L-1)/2)}$) varient selon L-1 par rapport auxdites N intégrales du diminuteur ($Int_{k-(N/2)-((L-1)/2)}$,...$Int_{k+(N/2)-1-((L-1)/2)}$).

7. Filtre numérique (Fx) selon la revendication 6, dans lequel :

   - lesdites N intégrales du diminuende ($Int_{k-(N/2)+((L-1)/2)}$,...$Int_{k+(N/2)-1+((L-1)/2)}$) sont une concaténation des (N/2)-((L-1)/2) dernières intégrales desdites N intégrales calculées précédemment ($Int_{k-N}$, $Int_{k-N+1}$, ... $Int_{k-1}$) et des (N/2)+((L-1)/2) premières intégrales desdites N intégrales calculées actuellement ($Int_k$, $Int_{k+1}$, ... $Int_{k+N-1}$) ; et
   - lesdites N intégrales du diminuteur ($Int_{k-(N/2)-((L-1)/2)}$,...$Int_{k+(N/2)-1-((L-1)/2)}$) sont une concaténation des (N/2)+((L-1)/2) dernières intégrales desdites N intégrales calculées précédemment ($Int_{k-N}$, $Int_{k-N+1}$, ... $Int_{k-1}$) et des (N/2)-((L-1)/2) premières intégrales desdites N intégrales calculées actuellement ($Int_k$, $Int_{k+1}$, ... $Int_{k+N-1}$).

8. Filtre numérique (Fx) selon la revendication 6 ou 7, dans lequel ledit circuit de différentiation (REG1, REG2, MUX1, MUX2, S2) comprend en outre un deuxième module d'addition (S2) connecté audit premier sélecteur (MUX1) et audit deuxième sélecteur (MUX2), ledit deuxième module d'addition (S2) étant configuré pour calculer N différences entre lesdites N intégrales du diminuende ($Int_{k-(N/2)+((L-1)/2)}$,...$Int_{k+(N/2)-1+((L-1)/2)}$) et lesdites N intégrales du diminuteur ($Int_{k-(N2)-((L-1)/2)}$,...$Int_{k+(N/2)-1-(L-1)/2)}$), lesdites N différences comprenant ladite différence entre ladite dernière intégrale ($Int_{k+((L-1)/2)}$) et ladite première intégrale ($Int_{k-((L-1]/2)}$).

9. Filtre numérique (Fx) selon l'une quelconque des revendications précédentes, dans lequel ledit module de somme cumulée (CS(8)) comprend $\log_2(N)$-1 modules de somme cumulée (SC(4), CS(2)) supplémentaires imbriqués les uns dans les autres.

10. Filtre numérique (Fx) selon la revendication 9, dans lequel :

   - ledit module de somme cumulée (CS(8)) comprend N/2 additionneurs d'entrée (Ai80, Ai81, Ai82, Ai83), (N/2)-1 additionneurs de sortie (Ao80, Ao81, Ao82) et un premier module de somme cumulée supplémentaire (CS(4)) interposé entre lesdits N/2 additionneurs d'entrée (Ai80, Ai81, Ai82, Ai83) et lesdits (N/2)-1 additionneurs de sortie (Ao80, Ao81, Ao82) ; et
   - ledit premier module de somme cumulée supplémentaire (CS(4)) comprend N/4 premiers additionneurs d'entrée supplémentaires (Ai40, Ai41), (N/4)-1 premiers additionneurs de sortie supplémentaires (Ao40) et un deuxième module de somme cumulée supplémentaire (CS(2)) interposé entre lesdits N/4 premiers additionneurs d'entrée supplémentaires (Ai40, Ai41) et lesdits (N/4)-1 premiers additionneurs de sortie supplémentaires (Ao40).

**11.** Filtre numérique (Fx) selon la revendication 9 ou 10, dans lequel lesdits modules de somme cumulée supplémentaires (SC(4), CS(2)) comprennent un module de somme cumulée supplémentaire le plus central (CS(2)) comprenant lui-même un seul additionneur.

**12.** Filtre numérique (Fx) selon l'une quelconque des revendications 1 à 8, dans lequel ledit module de somme cumulée (CS) comprend N additionneurs en cascade.

**13.** Compensateur de rotation (RC) pour un récepteur optique cohérent (RX) configuré pour recevoir un signal optique modulé (s(t)), traiter ledit signal optique modulé (s(t)) pour générer une composante en phase (I') et une composante en quadrature (Q'), et échantillonner ladite composante en phase (I') et ladite composante en quadrature (Q') pour générer des couples d'échantillons ($I'_k$, $Q'_k$) de ladite composante en phase (I') et de ladite composante en quadrature (Q'), lesdits couples d'échantillons ($I'_k$, $Q'_k$) formant une constellation reçue qui pivote par rapport à une constellation de référence selon un angle de rotation, ledit compensateur de rotation (RC) comprenant :

- un premier module d'angle (ANGL1) configuré pour recevoir en parallèle N couples d'échantillons ($I'_k$, $Q'_k$) et pour les convertir en N échantillons angulaires correspondants ($\theta'_k$) ;
- un circuit d'estimation (M1, SC1, Fx, Fy, ANGL2, M2, UW) configuré pour traiter lesdits N échantillons angulaires correspondants ($\theta'_k$) pour estimer N angles de rotation ($\alpha_k$) ;
- un circuit de compensation (D, S) configuré pour appliquer lesdits N angles de rotation ($\alpha_k$) auxdits N échantillons angulaires correspondants ($\theta'_k$), fournissant ainsi N échantillons angulaires compensés ($\theta''_k$) ; et
- un premier module sinus-cosinus (SC2) configuré pour recevoir lesdits N échantillons angulaires compensés ($\theta''_k$) en parallèle et pour les convertir en N couples correspondants d'échantillons compensés ($I''_k$, $Q''_k$),

dans lequel ledit circuit d'estimation (M1, SC1, Fx, Fy, ANGL2, M2, UW) comprend un filtre numérique (Fx, Fy) selon l'une quelconque des revendications précédentes.

**14.** Récepteur optique cohérent (RX) pour un réseau de communication optique configuré pour recevoir un signal optique modulé (s(t)) et pour traiter ledit signal optique modulé (s(t)) afin de générer une composante en phase (I') et une composante en quadrature (Q'), ledit récepteur optique cohérent (RX) comprenant un compensateur de rotation (RC) selon la revendication 13.

**15.** Réseau de communication optique comprenant un récepteur optique cohérent (RX) selon la revendication 14.

Figure 1

Figure 2

Figure 3

Figure 4

Figure 5

Figure 6

REG2

$Int_{k-8}$
$Int_{k-7}$
$Int_{k-6}$
$Int_{k-5}$
$Int_{k-4}$
$Int_{k-3}$
$Int_{k-2}$
$Int_{k-1}$

$Int_k$
$Int_{k+1}$
$Int_{k+2}$
$Int_{k+3}$
$Int_{k+4}$
$Int_{k+5}$
$Int_{k+6}$
$Int_{k+7}$

REG1

A2

A1

MUX2

MUX1

$Int_{k-5}$
$Int_{k-4}$
$Int_{k-3}$
$Int_{k-2}$
$Int_{k-1}$
$Int_k$
$Int_{k+1}$
$Int_{k+2}$

$Int_{k-3}$
$Int_{k-2}$
$Int_{k-1}$
$Int_k$
$Int_{k+1}$
$Int_{k+2}$
$Int_{k+3}$
$Int_{k+4}$

S2

$Int_{k-3}-Int_{k-5}$
$Int_{k-2}-Int_{k-4}$
$Int_{k-1}-Int_{k-3}$
$Int_k-Int_{k-2}$
$Int_{k+1}-Int_{k-1}$
$Int_{k+2}-Int_k$
$Int_{k+3}-Int_{k+1}$
$Int_{k+4}-Int_{k+2}$

Mx

1/3

$XAV_{k-4}=(1/3)\cdot(Int_{k-3}-Int_{k-5})$
$XAV_{k-3}=(1/3)\cdot(Int_{k-2}-Int_{k-4})$
$XAV_{k-2}=(1/3)\cdot(Int_{k-1}-Int_{k-3})$
$XAV_{k-1}=(1/3)\cdot(Int_k-Int_{k-2})$
$XAV_k=(1/3)\cdot(Int_{k+1}-Int_{k-1})$
$XAV_{k+1}=(1/3)\cdot(Int_{k+2}-Int_k)$
$XAV_{k+2}=(1/3)\cdot(Int_{k+3}-Int_{k+1})$
$XAV_{k+3}=(1/3)\cdot(Int_{k+4}-Int_{k+2})$

EP 2 381 596 B1

## Figure 7a

EP 2 381 596 B1

REG2

Int$_{k-8}$
Int$_{k-7}$
Int$_{k-6}$
Int$_{k-5}$
Int$_{k-4}$
Int$_{k-3}$
Int$_{k-2}$
Int$_{k-1}$

A2

MUX2

Int$_{k-6}$
Int$_{k-5}$
Int$_{k-4}$
Int$_{k-3}$
Int$_{k-2}$
Int$_{k-1}$
Int$_{k}$
Int$_{k+1}$

Int$_{k-2}$-Int$_{k-6}$
Int$_{k-1}$-Int$_{k-5}$
Int$_{k}$-Int$_{k-4}$
Int$_{k+1}$-Int$_{k-3}$
Int$_{k+2}$-Int$_{k-2}$
Int$_{k+3}$-Int$_{k-1}$
Int$_{k+4}$-Int$_{k}$
Int$_{k+5}$-Int$_{k+1}$

$XAV_{k-4}=(1/5)\cdot(Int_{k-2}-Int_{k-6})$
$XAV_{k-3}=(1/5)\cdot(Int_{k-1}-Int_{k-5})$
$XAV_{k-2}=(1/5)\cdot(Int_{k}-Int_{k-4})$
$XAV_{k-1}=(1/5)\cdot(Int_{k+1}-Int_{k-3})$
$XAV_{k}=(1/5)\cdot(Int_{k+2}-Int_{k-2})$
$XAV_{k+1}=(1/5)\cdot(Int_{k+3}-Int_{k-1})$
$XAV_{k+2}=(1/5)\cdot(Int_{k+4}-Int_{k})$
$XAV_{k+3}=(1/5)\cdot(Int_{k+5}-Int_{k+1})$

S2

Mx

1/5

Int$_{k}$
Int$_{k+1}$
Int$_{k+2}$
Int$_{k+3}$
Int$_{k+4}$
Int$_{k+5}$

A1

MUX1

REG1

Int$_{k+6}$
Int$_{k+7}$

Int$_{k-2}$
Int$_{k-1}$
Int$_{k}$
Int$_{k+1}$
Int$_{k+2}$
Int$_{k+3}$
Int$_{k+4}$
Int$_{k+5}$

## Figure 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 2785747

- US 4558454 A